# EUROPEAN PATENT SPECIFICATION

(11) **EP 4 365 939 B1**
(45) Date of publication and mention of the grant of the patent: **18.03.2026**
(21) Application number: 22869980.7
(22) Date of filing: 14.09.2022
(51) Int. Cl.: H01L 23/373, B29B 15/08, C08J 5/18, H01L 23/36, H05K 7/20

(54) **HEAT-DISSIPATING SHEET AND METHOD FOR MANUFACTURING THE SAME**
WÄRMEABLEITENDE FOLIE UND VERFAHREN ZUR HERSTELLUNG DAVON
FEUILLE DE DISSIPATION DE CHALEUR ET SON PROCÉDÉ DE FABRICATION

(30) Priority: 15.09.2021 JP 2021149842
(43) Date of publication of application: 08.05.2024
(73) Proprietor: Shin-Etsu Polymer Co., Ltd., Tokyo 100-0004 (JP)
(72) Inventor: NAKADA, Kazuya, Tokyo 100-0004 (JP)
(74) Representative: Arnold & Siedsma
(86) International application number: PCT/JP2022/034325
(87) International publication number: WO 2023/042833

(56) References cited:
- WO-A1-2021/090929
- JP-A- 2002 088 171
- JP-A- 2002 088 171
- JP-A- 2007 326 976
- JP-A- 2007 326 976
- JP-A- 2013 131 564
- JP-A- 2013 131 564
- JP-A- 2015 092 534
- JP-A- 2015 092 534
- JP-A- 2015 216 387

## Description

### Cross Reference

The present application claims priority based on Japanese Patent Application No. 2021-149842 filed in Japan on September 15, 2021

### Technical Field

The present invention relates to a heat-dissipating sheet and a method for manufacturing the same.

### Background Art

Control systems for automobiles, aircraft, ships, or household or commercial electronic equipment are becoming more accurate and complex. Accordingly, the integration density of small electronic components on circuit boards continues to increase. As a result, there is a strong desire to solve the problems of failure and shortened lifespan of the electronic components due to heat generation around circuit boards.

To achieve quick heat dissipation from a circuit board, there has been conventionally known a technique of interposing a heat-dissipating sheet between a heat source such as a circuit board and a cooling member such as a heat sink or a cooling fan. The heat-dissipating sheet widely used is a sheet made of a rubbery elastic body such as resin or rubber in which a thermally conductive filler is contained in a dispersed manner. Furthermore, a heat-dissipating sheet has recently been known in which carbon fibers serving as a thermally conductive filler are oriented in the thickness direction of the heat-dissipating sheet (see, for example, Patent Literature 1). Patent Literature 2 discloses a heat-conductive sheet obtained by imparting a magnetic field to a heat-conductive polymer composition containing heat-conductive fibers, inclining the heat-conductive fibers in the thickness direction of the sheet, namely in the direction vertical to the surface of the sheet, and then solidifying the composition. Patent Literature 3 discloses a silicone heat conduction sheet formed by a silicone hardened material in which a heat conductive filler is mixed, wherein multiple holes are provided on the silicone heat conduction sheet.

### Citation List

### Patent Literature

Patent Literature 1: Japanese Patent Laid-Open No. 2010-56299
Patent Literature 2: Japanese Patent Laid-Open No. 2002-88171
Patent Literature 3: Japanese Patent Laid-Open No. 2015-92534

### Summary of Invention

### Technical Problem

Such heat-dissipating sheets are required to further improve their thermal conductivity. A common method to obtain high thermal conductivity is increasing the filling rate of the thermally conductive filler such as a carbon fiber contained in the heat-dissipating sheet. However, increase in the filling rate of the thermally conductive filler causes the heat-dissipating sheet to have a high hardness that may cause loss of flexibility. The heat-dissipating sheet with high hardness decreases in adhesion to the heat source and the cooling member, so that the thermal conductivity may decrease. Furthermore, the conventionally known heat-dissipating sheet as described above is manufactured by slicing a flexible sheet precursor, which is molded so that carbon fibers are oriented in one direction in a plane, on a plane perpendicular to the orientation direction. The heat-dissipating sheet manufactured in this way has a large surface roughness on the cut surface, which increases the thermal resistance at the contact interface with the heat source and/or the cooling member, so that the thermal conductivity may decrease in the thickness direction of the heat-dissipating sheet. This applies not only to circuit boards, but also to other heat sources such as electronic components, electronic device bodies, or battery cells.

To solve the above problems, an object of the present invention is to provide a heat-dissipating sheet capable of achieving low hardness and high thermal conductivity, and a method for manufacturing the same.

### Solution to Problem

The invention is given by a heat-dissipating sheet according to claim 1 and a method for manufacturing a heat-dissipating sheet according to claim 12.
(1) A heat-dissipating sheet according to an embodiment for achieving the above object includes:
   at least one sheet-shaped rubbery elastic body; and
   an elongated thermally conductive filler that has better thermal conductivity than the rubbery elastic body, and is embedded in the rubbery elastic body and obliquely oriented with respect to a thickness direction of the rubbery elastic body, in which
   both end portions of the thermally conductive filler are respectively exposed on surfaces of the rubbery elastic body, and the rubbery elastic body has at least one hole oriented obliquely with respect to the thickness direction of the rubbery elastic body.
(3) The heat-dissipating sheet according to still another embodiment may preferably have a configuration in which the thermally conductive filler is embedded in the rubbery elastic body and oriented at an angle greater than 45° and smaller than 85° with respect to a surface of the rubbery elastic body.
(4) The heat-dissipating sheet according to still another embodiment may preferably have a configuration in which the thermally conductive filler has both the end portions, exposed on a surface of the rubbery elastic body, each having a diameter larger than a diameter of a region embedded in the rubbery elastic body.
(5) The heat-dissipating sheet according to still another embodiment may preferably include a silicone rubber, formed of cured liquid rubber, between each rubbery elastic body and the hole or between the rubbery elastic bodies such that the silicone rubber is arranged between the hole of one of the rubbery elastic bodies and the hole of the other of the rubbery elastic bodies.
(6) The heat-dissipating sheet according to still another embodiment may preferably have a configuration in which the liquid rubber is a liquid silicone rubber.
(7) The heat-dissipating sheet according to still another embodiment may preferably have a configuration in which each rubbery elastic body is a silicone rubber.
(8) The heat-dissipating sheet according to still another embodiment may preferably have a configuration in which at least one of a front side surface and a back side surface of each rubbery elastic body has a coating layer of lubricant.
(9) The heat-dissipating sheet according to still another embodiment may preferably have a configuration in which the hole of each rubbery elastic body has lubricant.
(10) The heat-dissipating sheet according to still another embodiment may preferably have a configuration in which at least one of a front side surface and a back side surface of each rubbery elastic body has a coating layer of the lubricant.
(11) The heat-dissipating sheet according to still another embodiment may preferably have a configuration in which the hole positioned at an outermost circumference in a plane of each rubbery elastic body in plan view does not contain the lubricant, and an inner region in the plane relative to the hole positioned at the outermost circumference has the lubricant.
(12) The heat-dissipating sheet according to still another embodiment may preferably have a configuration in which the thermally conductive filler is a carbon fiber.
(13) A method for manufacturing a heat-dissipating sheet according to an embodiment for achieving the above object is a method for manufacturing any one of the above heat-dissipating sheets and includes:
   a discharge step of discharging curable rubber composition, containing the thermally conductive filler, onto a plane of a plane body in a plurality of rows each extending in a first predetermined direction;
   a molding step of molding the curable rubber composition, discharged onto the plane, into a sheet shape and curing the curable rubber composition, to form at least one filler-containing sheet, the filler-containing sheet having the thermally conductive filler oriented in the first predetermined direction and having a surface with at least one depressed portion in a second predetermined direction;
   a laminating step of laminating a plurality of the filler-containing sheets with uncured liquid rubber arranged between the filler-containing sheets and curing the uncured liquid rubber, to form a block body that is a laminate having the thermally conductive fillers with the same orientation; and
   a cutting step of cutting the block body into a sheet shape obliquely with respect to an orientation direction of the thermally conductive filler.
(14) The method for manufacturing the heat-dissipating sheet according to another embodiment may preferably be a method in which the laminating step laminates the plurality of filler-containing sheets so that positions of the depressed portions are at different positions between the filler-containing sheets in a thickness direction of the filler-containing sheets.
(15) The method for manufacturing the heat-dissipating sheet according to still another embodiment may preferably be a method in which a lubricant supplying step is performed that supplies lubricant to at least one of a front side surface and a back side surface of each rubbery elastic body and/or an inside of the hole after the cutting step.

### Advantageous Effects of Invention

The present invention can provide a heat-dissipating sheet capable of achieving low hardness and high thermal conductivity, and a method for manufacturing the same.

### Brief Description of Drawings

[Figure 1] Figure 1 shows a plan view of a heat-dissipating sheet according to a first embodiment of the present invention and an enlarged view of a portion B thereof.
[Figure 2] Figure 2 shows a cross-sectional view taken along a line A-A of the heat-dissipating sheet in Figure 1, an enlarged view of a portion C thereof, and an enlarged view of a portion D thereof.
[Figure 3] Figure 3 shows an example of a flow of main steps of the method for manufacturing the heat-dissipating sheet according to the first embodiment of the present invention.
[Figure 4] Figure 4 shows statuses at the steps of the manufacturing method of Figure 3 in plan views and a cross-sectional view.
[Figure 5] Figure 5 shows statuses at the steps following Figure 4 in cross-sectional views.
[Figure 6] Figure 6 shows statuses at the steps following Figure 5 in plan views.
[Figure 7] Figure 7 shows statuses of the steps following Figure 6 in cross-sectional views.
[Figure 8] Figure 8 shows statuses of the steps following Figure 7 in perspective views.
[Figure 9] Figure 9 shows a plan view of a heat-dissipating sheet according to a second embodiment of the present invention and an enlarged view of a portion B thereof.
[Figure 10] Figure 10 shows a cross-sectional view taken along a line A-A of the heat-dissipating sheet of Figure 9, an enlarged view of a portion C thereof, and an enlarged view of a portion D thereof.
[Figure 11] Figure 11 shows a plan view of a first modification of the heat-dissipating sheet of Figure 9.
[Figure 12] Figure 12 is a diagram showing a second modification of the heat-dissipating sheet of Figure 9, and shows a cross-sectional view similar to the cross-sectional view taken along the line A-A in Figure 9 and an enlarged view of a portion C thereof.
[Figure 13] Figure 13 is a diagram showing a third modification of the heat-dissipating sheet of Figure 9, and shows a cross-sectional view similar to the cross-sectional view taken along the line A-A in Figure 9 and an enlarged view of a portion C thereof.
[Figure 14] Figure 14 shows a cross-sectional view of a status in which the heat-dissipating sheet according to the third modification is in the middle of being sandwiched between a cooling member and a heat source.
[Figure 15] Figure 15 shows a cross-sectional view of a status, having progressed further from the status in Figure 14, in which the heat-dissipating sheet has been completely sandwiched between the cooling member and the heat source.
[Figure 16] Figure 16 shows a comparison, in cross-sectional views, between: an example (16A) in which a heat sink, which is an example of a cooling member, is brought into contact with a conventional heat-dissipating sheet having no hole, with lubricant supplied on a surface thereof; and an example (16B) in which a heat sink is brought into contact with the heat-dissipating sheet of Figure 9 with lubricant supplied on a surface thereof.
[Figure 17] Figure 17 shows a plan view of a heat-dissipating sheet according to a fourth modification and a cross-sectional view taken along a line A-A of the plan view.
[Figure 18] Figure 18 shows a plan view of a heat-dissipating sheet according to a fifth modification and a cross-sectional view taken along a line A-A of the plan view.
[Figure 19] Figure 19 shows a plan view of a heat-dissipating sheet according to a sixth modification and a cross-sectional view taken along a line A-A of the plan view.
[Figure 20] Figure 20 shows a plan view of a heat-dissipating sheet according to a seventh modification and a cross-sectional view taken along a line A-A of the plan view.
[Figure 21] Figure 21 shows a flow of a manufacturing method in which holes are formed after a cutting step of a block body.
[Figure 22] Figure 22 shows a flow of a manufacturing method in which lubricant is supplied to a rubbery elastic body after a hole forming step.
[Figure 23] Figure 23 shows a photograph of a heat-dissipating sheet according to a first modification of the second embodiment.
[Figure 24] Figure 24 shows a modification of the flow diagram of Figure 22.

### Reference Signs List

1... heat-dissipating sheet, 10... rubbery elastic body, 11, 12... surface, 14... hole, 20... carbon fiber (an example of thermally conductive filler), 21, 22... both end portions (of carbon fiber that is an example of thermally conductive filler), 23... region embedded in rubbery elastic body (of carbon fiber that is an example of thermally conductive filler), 30... silicone rubber, 45... coating layer, 45a... lubricant, 70... curable rubber composition, 72, 74... film (an example of plane body), 76, 80, 82... carbon-containing sheet (an example of filler-containing sheet), 78... depressed portions, 85... uncured liquid rubber, 90... block body, Φ1... diameter of both end portions of carbon fiber that is an example of thermally conductive filler, Φ2... diameter of region of carbon fiber, which is an example of thermally conductive filler, embedded in rubbery elastic body, D1... first predetermined direction, D2... second predetermined direction.

### Description of Embodiments

Embodiments of the present invention will be described with reference to the drawings.

### (First Embodiment)

### 1. Heat-dissipating sheet

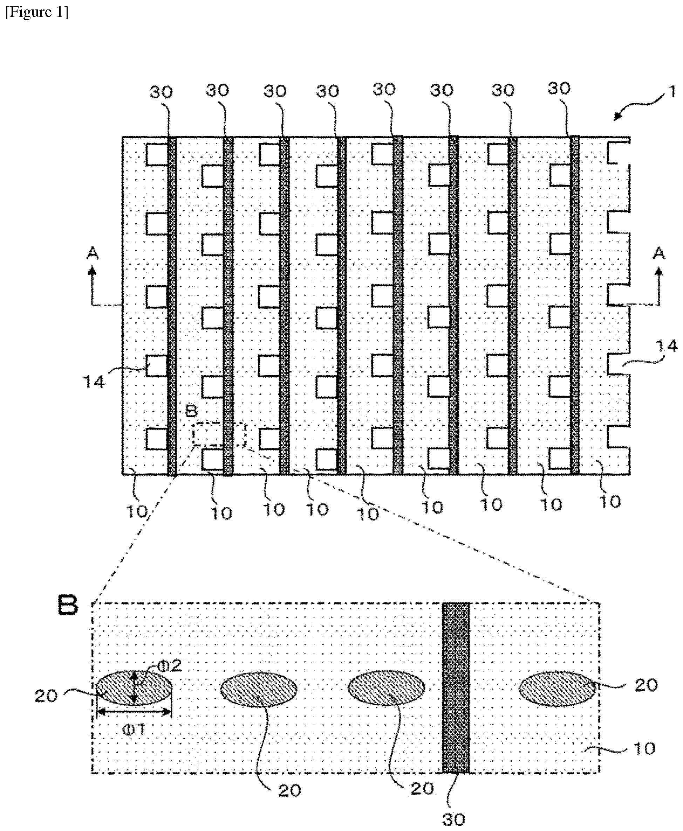

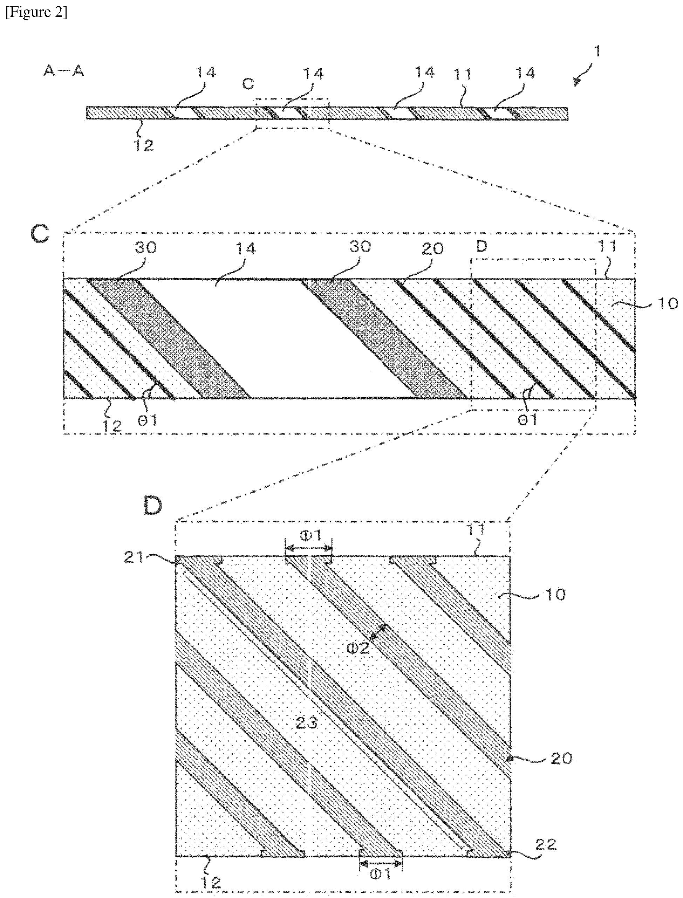

Figure 1 shows a plan view of a heat-dissipating sheet according to a first embodiment of the present invention and an enlarged view of a portion B thereof. Figure 2 shows a cross-sectional view taken along a line A-A of the heat-dissipating sheet of Figure 1, an enlarged view of a portion C thereof, and an enlarged view of a portion D thereof.

The heat-dissipating sheet 1 according to this embodiment is a sheet, with excellent thermal conductivity, that conducts heat from a heat source to a member on the cooling side to allow heat dissipation from the heat source. The "heat-dissipating sheet" may also be referred to as a "thermal-conductive sheet." In this embodiment, the heat-dissipating sheet 1 is a sheet to be used in arrangement between the heat source and the member on the cooling side so that one surface 11 of rubbery elastic bodies 10 in the thickness direction is in contact with the heat source and the other surface 12 thereof in the thickness direction is in contact with the member on the cooling side. The heat-dissipating sheet 1 includes the sheet-shaped rubbery elastic bodies 10 and carbon fibers 20 embedded and oriented obliquely with respect to the thickness direction of the rubbery elastic bodies 10 (up-down direction in Figure 2). The surfaces 11 and 12 are the largest surfaces of the rubbery elastic bodies 10, and mean surfaces that are visible in plan view of the rubbery elastic bodies 10. Furthermore, the surface 11 means a "front side surface." The surface 12 means a "back side surface". Each carbon fiber 20 is an example of an elongated thermally conductive filler. The thermally conductive filler has better thermal conductivity than the rubbery elastic body 10. The following embodiments will be described mainly with an example in which the carbon fiber 20 is used as the thermally conductive filler. The rubbery elastic body 10 includes at least one hole 14 oriented obliquely with respect to its thickness direction (up-down direction in Figure 2). Both end portions 21 and 22 of the carbon fiber 20 are respectively exposed on the surfaces 11 and 12 of the rubbery elastic body 10. The hole 14 is preferably larger than 0% and smaller than 80%, and more preferably larger than 20% and smaller than 60%, with respect to the area of the surface 11 or the surface 12 of the rubbery elastic body 10. This also applies to a second embodiment described later. When the hole 14 is inclined, the inclination angle of the hole 14 is preferably greater than 0° and smaller than 80°, more preferably greater than 20° and smaller than 50°, with respect to the surface 11 or the surface 12. This also applies to a second embodiment described later.

In this embodiment, the heat-dissipating sheet 1 is a member in which a plurality of the rubbery elastic bodies 10 are laminated to form one sheet in plan view. In the heat-dissipating sheet 1, preferably, silicone rubbers 30 made by curing uncured liquid rubber are arranged between the plurality of the rubbery elastic bodies 10. Each silicone rubber 30 is preferably arranged between the rubbery elastic body 10 and the hole 14 in the thickness direction (up-down direction in Figure 2) of the heat-dissipating sheet 1 (see enlarged view of a portion C in Figure 2). The uncured liquid rubber serves as adhesive for bonding the rubbery elastic bodies 10 together. Next, components of the heat-dissipating sheet 1 will be described.

### (1) Rubbery elastic body

The rubbery elastic body 10 is not particularly limited and can be appropriately selected depending on the required performance of the heat-dissipating sheet, and an example thereof includes thermosetting resin or thermoplastic resin. Examples of the thermosetting resin include elastomeric thermosetting resins such as silicone rubber, silicone resin, polyurethane resin, and epoxy resin. Examples of the thermoplastic resin include elastomeric thermoplastic resins such as synthetic rubber, polyethylene resin, polyurethane resin, ABS resin, and soft vinyl chloride resin. In these types, one type may be used alone or two or more types may be used in combination. Among these, silicone rubber is particularly preferred because it has excellent moldability, weather resistance, and heat resistance, as well as adhesion and followability to heat sources such as electronic components. The rubbery elastic body 10 may include a resin material as described above and a filler having higher thermal conductivity than that of the resin material. As a result, the rubbery elastic body 10 has higher thermal conductivity than that of a body made of only a resin material, so that the thermal conductivity from the heat source to the member on the cooling side can be further increased. The filler to be selected may be particulate filler, fibrous filler, plate-shaped filler, or acicular filler, typically made of aluminum oxide (Al₂O₃), aluminum nitride (AlN), cubic boron nitride (cBN), hexagonal boron nitride (hBN), zinc oxide, silicon carbide, aluminum hydroxide, or diamond. The filler with high insulation is more preferred.

### (2) Elongated thermally conductive filler

The carbon fiber 20 as an example of an elongated thermally conductive filler is preferably oriented so that an angle θ1 with respect to the surfaces 11 and 12 of the rubbery elastic body 10 is greater than 45° and smaller than 85°, and is embedded in the rubbery elastic body 10. In the heat-dissipating sheet 1, making the angle θ1 greater than 45° allows preventing decrease in thermal conductivity in the thickness direction. Furthermore, in the heat-dissipating sheet 1, making the angle θ1 smaller than 85° allows preventing increase in hardness. Note that the angle θ1 may be greater than 0° and smaller than 45°. The surfaces of both the end portions 21 and 22 of the carbon fiber 20 are preferably flush respectively with the surfaces 11 and 12 of the rubbery elastic body 10, and do not protrude or do not recess from the surfaces 11 and 12 significantly. The carbon fiber 20 preferably has both the end portions 21 and 22, exposed on the surfaces 11 and 12 of the rubbery elastic body 10, each of which has a larger diameter Φ1 than a diameter Φ2 of the region 23 embedded in the rubbery elastic body 10. The size ratio of Φ1 to Φ2 is preferably 1 < Φ1/Φ2 < 2, more preferably 1.5 < Φ1/Φ2 < 2. The heat-dissipating sheet 1 has the carbon fibers 20 having the larger diameter Φ1 at each of both the end portions 21 and 22 than the diameter Φ2 in the other region 23. Therefore, for example, even if an external force is applied in the direction of pulling out the carbon fibers 20 (orientation direction of the carbon fibers 20), the carbon fibers 20 can be prevented from being pulled out from the rubbery elastic bodies 10. Furthermore, in the heat-dissipating sheet 1, the carbon fibers 20 having both the end portions 21 and 22, each having the diameter Φ1, are in contact with the heat source or the member on the cooling side. This increases the contact area between each carbon fiber 20 and the heat source or the member on the cooling side to allow increase in the thermal conductivity. Note that the orientation angle θ1 of each carbon fiber 20 is not limited to the above range as long as the orientation angle θ1 is at least oblique with respect to the thickness direction of the rubbery elastic body 10.

Although each carbon fiber 20 is not particularly limited, it is preferably an anisotropic pitch-based carbon fiber. However, the carbon fiber 20 is not limited to an anisotropic pitch-based carbon fiber, and may be other carbon fibers such as PAN-based carbon fibers, isotropic pitch-based carbon fibers, amorphous carbon fibers, carbon nanotubes, graphite nanofibers, or diamond fibers, or may be a mixture of two or more of these carbon fibers. The fiber length of the carbon fiber 20 is preferably 0.002 mm to 10 mm, more preferably 0.005 mm to 7.5 mm. The fiber diameter of the carbon fiber 20 is preferably 1 µm to 50 µm, more preferably 5 to 25 µm.

### (3) Silicone rubber

The silicone rubber 30 is a silicone rubber, made by curing uncured liquid rubber, that has low fluidity or is solid. Uncured liquid rubber is a highly fluid rubber that can be cured by a desired method. Examples of methods for curing uncured liquid rubber include heating, light irradiation, electron beam irradiation, and curing with a catalyst or a curing agent. Examples of uncured liquid rubber include liquid silicone rubber, liquid natural rubber, liquid isoprene rubber, liquid butadiene rubber, liquid styrene-butadiene rubber, liquid butyl rubber, liquid nitrile rubber, liquid ethylene-propylene rubber, liquid chloroprene rubber, liquid chlorosulfonated polyethylene rubber, liquid urethane rubber, and liquid fluororubber. Among these, liquid silicone rubber is preferred because it is less susceptible to dimensional changes and warping after curing, has low compression permanent set, and has high heat resistance. The liquid silicone rubber may be either a condensation type or an addition type.

The heat-dissipating sheet 1 includes a plurality of the holes 14 oriented obliquely with respect to the thickness direction (up-down direction in Figure 2) of the rubbery elastic bodies 10. The holes 14 are preferably through holes that penetrate from one surface 11 of each rubbery elastic body 10 to the other surface 12 thereof in the thickness direction. More preferably, the heat-dissipating sheet 1 has a plurality of the holes 14 arranged at predetermined intervals on the surfaces 11 and 12. However, the number, the arrangement, the form, etc. of the holes 14 are not particularly limited, and are preferably designed as appropriate depending on the required performance and the like of the heat-dissipating sheet. Furthermore, the holes 14 do not need to penetrate from one surface 11 to the other surface 12. In this embodiment, the holes 14 are provided substantially parallel to the orientation direction of the carbon fibers 20 (see the enlarged view of a portion C in Figure 2). However, the holes 14 do not need to be arranged parallel to the orientation direction of the carbon fibers 20 as long as they are oriented obliquely with respect to the thickness direction of the rubbery elastic body 10. The heat-dissipating sheet 1 configured in this manner can prevent increase in hardness due to the holes 14 oriented obliquely with respect to the thickness direction. Furthermore, the heat-dissipating sheet 1 is compressed in the thickness direction between the heat source and the member on the cooling side. Since the heat-dissipating sheet 1 includes the holes 14, stress on the carbon fibers 20 can be reduced and breakage of the carbon fibers 20 can be prevented even in deformation due to the compression.

The heat-dissipating sheet 1 preferably has an arithmetic mean roughness Ra of 1.0 µm or more and 1.8 µm or less on the surfaces 11 and 12 perpendicular to the thickness direction (up-down direction in Figure 2). Furthermore, the heat-dissipating sheet 1 preferably has a ten-point mean roughness Rz of the surfaces 11 and 12 of 7.7 µm or more and 18 µm or less. Note that the arithmetic mean roughness Ra is a value measured according to JIS B 0601-2001. The ten-point mean roughness Rz is a value measured according to JIS B 0601-1994. Reducing the surface roughness of the heat-dissipating sheet 1 in this way flattens the surfaces 11 and 12 perpendicular to the thickness direction of the heat-dissipating sheet 1, to allow the heat source to be in contact with the carbon fibers 20 more reliably and allow the thermal conductivity to increase.

### 2. Method for manufacturing heat-dissipating sheet

Next, a method for manufacturing a heat-dissipating sheet according to the first embodiment of the present invention will be described.

The method for manufacturing the heat-dissipating sheet 1 includes: a discharge step of discharging curable rubber composition, containing carbon fibers 20, onto a plane of a plane body in a plurality of rows each extending in the first predetermined direction; a molding step of molding the curable rubber composition discharged onto the plane of the plane body into a sheet shape and curing the curable rubber composition to form a carbon-containing sheet (an example of a filler-containing sheet), which has the carbon fibers 20 oriented in a first predetermined direction and has a surface with at least one depressed portion in a second predetermined direction; a laminating step of laminating a plurality of the carbon-containing sheets with uncured liquid rubber arranged between the carbon-containing sheets and curing the uncured liquid rubber to form a block body that is a laminate having the carbon fibers 20 with the same orientation; a cutting step of cutting the block body into a sheet shape obliquely with respect to the orientation direction of the carbon fibers 20. The following embodiments will be described mainly with an example in which the carbon-containing sheet is used as the filler-containing sheet.

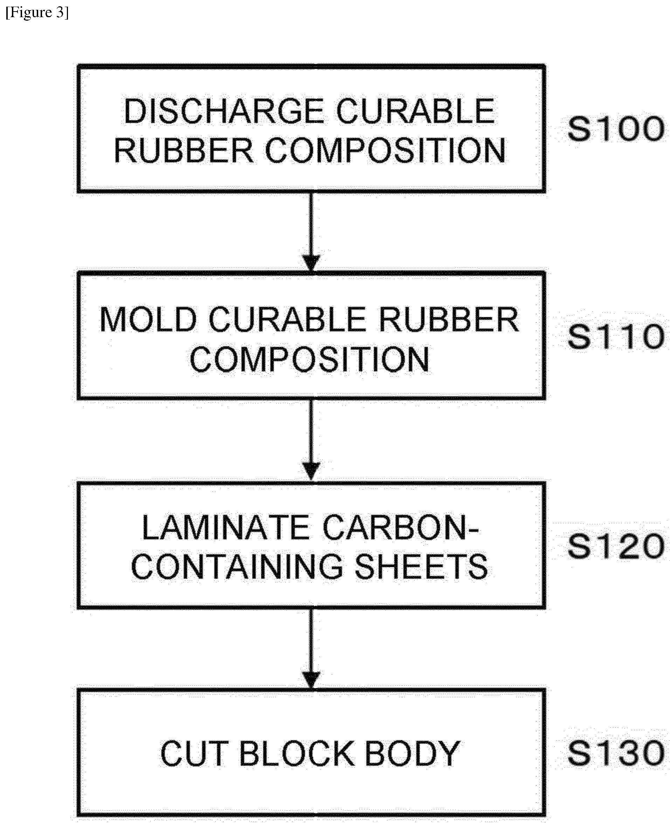

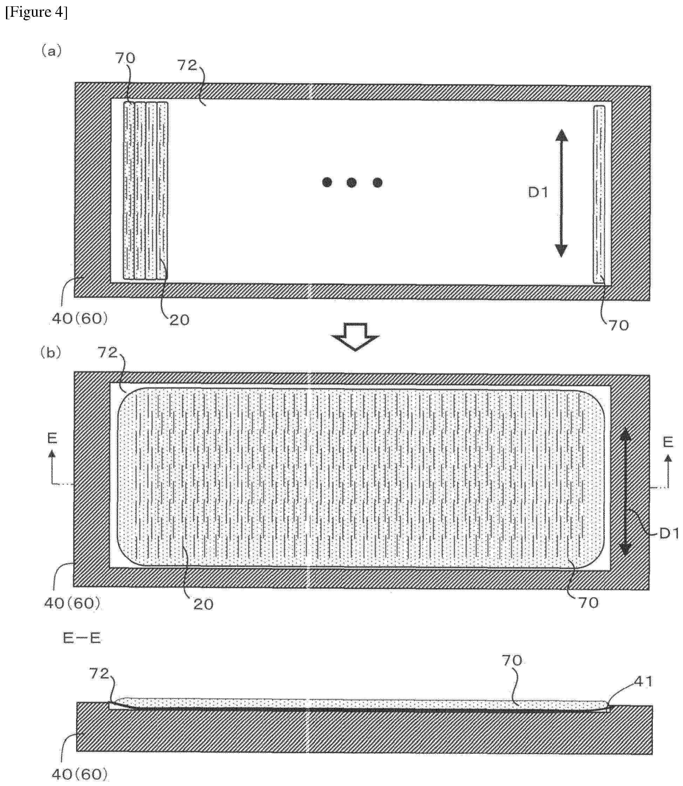

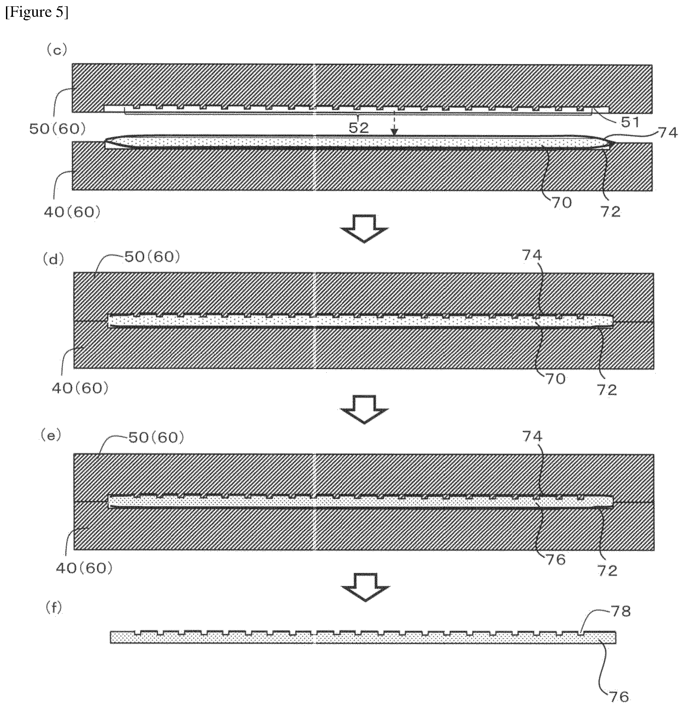

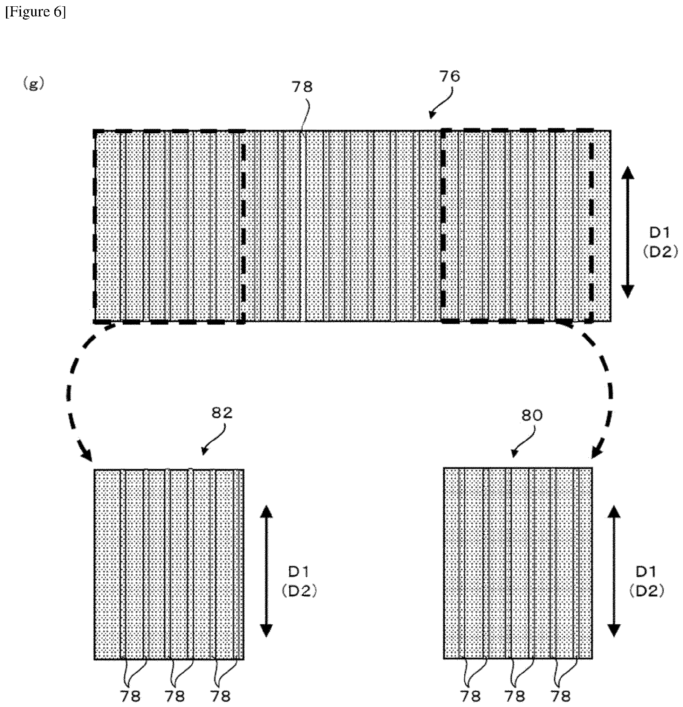

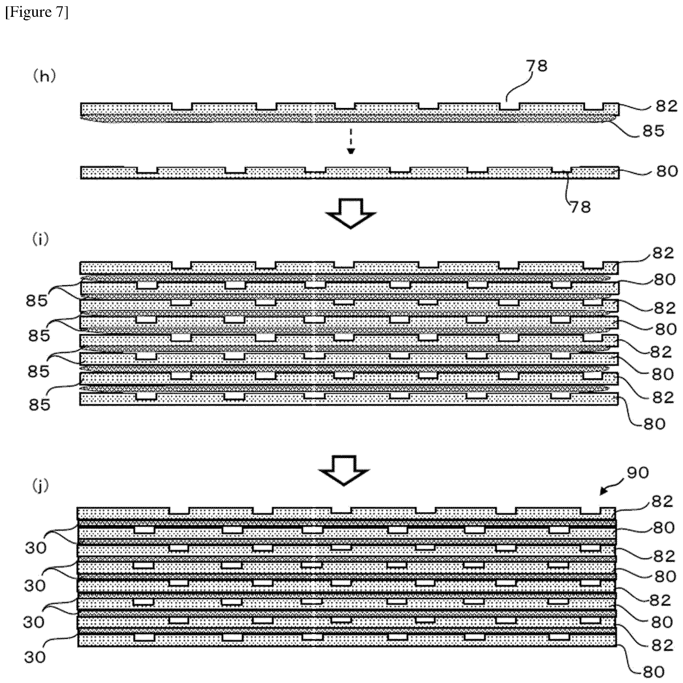

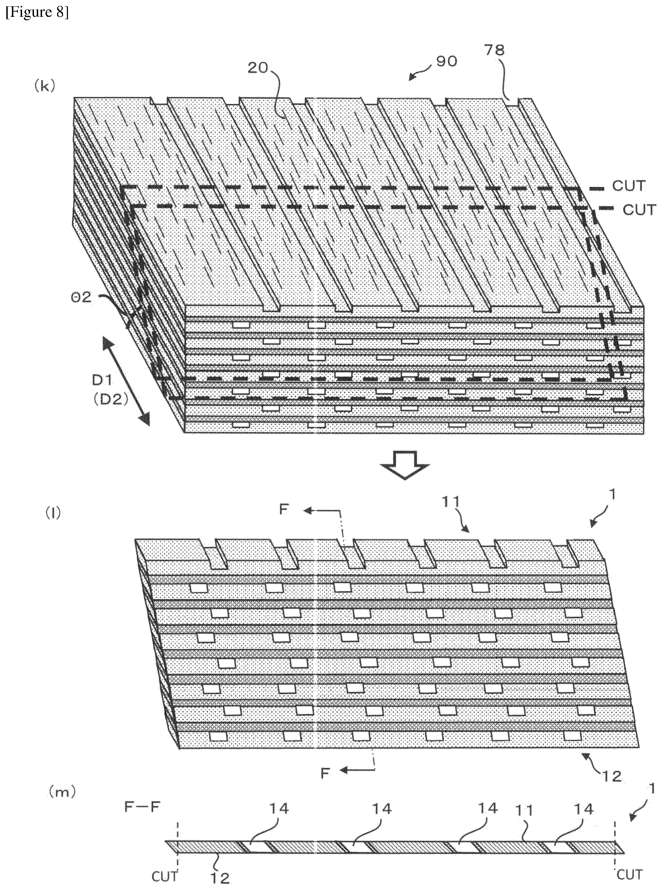

Figure 3 shows an example of a flow of the main steps of the method for manufacturing the heat-dissipating sheet according to the first embodiment of the present invention. Figure 4 shows statuses at the steps of the manufacturing method of Figure 3 in plan views and a cross-sectional view. Figure 5 shows statuses at the steps following Figure 4 in cross-sectional views. Figure 6 shows the statuses at the steps following Figure 5 in plan views. Figure 7 shows statuses of the steps following Figure 6 in cross-sectional views. Figure 8 shows statuses of the steps following Figure 7 in perspective views. Note that, in Figure 4 and Figure 8, the carbon fibers 20 are drawn in an exaggerated manner for description of the manufacturing steps.

The heat-dissipating sheet 1 can be manufactured through a discharge step (S100), a molding step (S110), a laminating step (S120), and a cutting step (S130). Hereinafter, S100 to S130 will be described in detail with reference to Figures 3 to 8.

### (1) Discharge step (S100)

This step is a step of discharging curable rubber composition 70, containing carbon fibers 20, onto a plane of a film (an example of a plane body) 72 in a plurality of rows each extending in a first predetermined direction D1 (up-down direction in Figure 4(a)) (see Figure 4). In this embodiment, the discharge step (S100) preferably discharges the curable rubber composition 70 onto a film 72 with the film 72 placed in the recess 41 (see the cross-sectional view taken along a line E-E in Figure 4(b)) of the lower mold 40 configuring the mold 60 to be used in the molding step (S110) described later. Furthermore, the discharge step (S100) linearly discharges the curable rubber composition 70 in the first predetermined direction D1 in a plurality of rows so that the rows are lined up in a direction orthogonal to the first predetermined direction D1 (left-right direction in Figure 4(a)) (see Figure 4(a)). Thereby, the discharge step (S100) forms a sheet-shaped curable rubber composition 70 on the film 72 (see Figure 4(b)). The curable rubber composition 70 is a composition that becomes the rubbery elastic body 10 after curing. The discharge step (S100) discharges the curable rubber composition 70 containing the carbon fibers 20 in the first predetermined direction D1, allowing the carbon fibers 20 to be oriented in the first predetermined direction D1. Hereinafter, the first predetermined direction D1 is also referred to as a carbon fiber orientation direction D1 or a discharge direction D1. The film 72 is preferably a film made of resin. Examples of the resin include polyethylene terephthalate (PET), polyethylene naphthalate, polyethylene isophthalate, polybutylene terephthalate, polyacetate, polycarbonate, polyphenylene sulfide, polyamide, polyvinyl chloride, and polyvinylidene chloride. Among these, PET film is more preferable as the film 72.

### (2) Molding step (S110)

This step is a step of molding the curable rubber composition 70 discharged onto the film 72 into a sheet shape and curing the curable rubber composition 70, to form a carbon-containing sheet 76 having the carbon fibers 20 oriented in the first predetermined direction D1 and having at least one depressed portion 78 on a surface thereof in a second predetermined direction D2 (see Figure 5). In this embodiment, the second predetermined direction D2 is the same direction as the first predetermined direction D1 (the paper depth direction in Figure 5). However, in plan view of the carbon-containing sheet 76, the first predetermined direction may deviate from the second predetermined direction by preferably 20 degrees or less, more preferably 10 degrees or less, and still more preferably 5 degrees or less. Furthermore, in this embodiment, the carbon-containing sheet 76 includes a plurality of the depressed portions 78 at a predetermined interval in a direction orthogonal to the second predetermined direction D2 (left-right direction in Figure 5). More specifically, first, the plane of the film (an example of a plane body) 74 is stacked on top of the curable rubber composition 70 that has been discharged onto the film 72. The film 74 is preferably made of the same material as the film 72 described above. Next, the upper mold 50 configuring the mold 60 is prepared and stacked on the recess 41 side of the lower mold 40, and the lower mold 40 and the upper mold 50 are closed together (see Figures 5(c) and 5(d)). The upper mold 50 has a recess 51 on a surface facing the recess 41 of the lower mold 40. The recess 51 has projections and depressions 52, on its inner bottom surface, that can form the depressed portions 78 by transfer. After the mold 60 is clamped, it is heated to mold the curable rubber composition 70 (see Figure 5(e)). As a result, the curable rubber composition 70 is cured to form the rubbery elastic body 10 containing the carbon fibers 20. Furthermore, the depressed portions 78 is formed by transfer of the projections and depressions 52. Then, the mold 60 is opened and the films 72 and 74 are peeled off to form the carbon-containing sheet 76 (see Figure 5(f)). The carbon-containing sheet 76 is a sheet in which the rubbery elastic body 10 contains the carbon fibers 20 oriented in the first predetermined direction D1 (the paper depth direction in Figure 5(f)). Furthermore, the carbon-containing sheet 76 is a sheet that includes a plurality of the depressed portions 78 at a predetermined interval in a direction (left-right direction in Figure 5) orthogonal to the second predetermined direction D2 (see Figure 6(g)).

In this embodiment, in the molding step (S110), two types of carbon-containing sheets 80 and 82 are cut out from the carbon-containing sheet 76 (see Figure 6(g)). The carbon-containing sheet 80 has different positions of the depressed portions 78 from the carbon-containing sheet 82 in the direction orthogonal to the second predetermined direction D2 (left-right direction in Figure 6). Furthermore, the carbon-containing sheets 80 and 82 contain the carbon fibers 20 oriented in the first predetermined direction D1 (up-down direction in Figure 6). In this embodiment, the molding step (S110) preferably cuts out the carbon-containing sheet 76 in the second predetermined direction D2 (up-down direction in Figure 6), so that the positions of the depressed portions 78 are different in the direction orthogonal to the second predetermined direction D2 (left-right direction in Figure 6), to form the carbon-containing sheets 80 and 82. In this embodiment, the carbon-containing sheet 80 and the carbon-containing sheet 82 are sheets of the same size, but may be sheets of different sizes. Furthermore, the method for cutting out the carbon-containing sheets 80 and 82 from the carbon-containing sheet 76 is not particularly limited as long as it is a method that can form two types of carbon-containing sheets 80 and 82.

### (3) Laminating step (S120)

This step is a step of: laminating a plurality of the carbon-containing sheets 80 and 82 with uncured liquid rubber 85 arranged between the carbon-containing sheets 80 and 82; and curing the uncured liquid rubber 85, to form a block body 90 that is a laminate having the carbon fibers 20 with the same orientation (see Figure 7). Furthermore, this step is preferably a step of laminating a plurality of the carbon-containing sheets 80 and 82 so that the positions of the depressed portions 78 of the carbon-containing sheets 80 and 82 are at different positions from each other in the thickness direction of the carbon-containing sheets 80 and 82 (up-down direction in Figure 7). More specifically, the uncured liquid rubber 85 is first placed between the carbon-containing sheets 80 and 82, and the carbon-containing sheet 82 is stacked thereon (see Figure 7(h)). At this time, the two carbon-containing sheets 80 and 82 are stacked so that the orientation directions D1 of the carbon fibers 20, which are contained in each of the two carbon-containing sheets 80 and 82 stacked with the uncured liquid rubber 85 in between, are the same direction. The uncured liquid rubber 85 is preferably applied to the lower surface (i.e., the surface without projections and depressions) of the carbon-containing sheet 82. This is because it is easier to apply the uncured liquid rubber 85 to the carbon-containing sheet 82 in a thin and uniform thickness. Furthermore, at this time, the two carbon-containing sheets 80 and 82 are stacked so that the positions of the depressed portions 78 of the two carbon-containing sheets 80 and 82, stacked with the uncured liquid rubber 85 in between, are at different positions in the thickness direction of the carbon-containing sheets 80 and 82. **In** other words, the laminating step (S120) stacks the two carbon-containing sheets 80 and 82 so that the depressed portions 78 of the carbon-containing sheet 80 and the depressed portions 78 of the carbon-containing sheet 82 are not arranged on the same straight line in the thickness direction (up-down direction in Figure 7) (see Figures 7(h) and 7(i)). This operation is repeated to stack the carbon-containing sheets 80 and 82 alternately with the uncured liquid rubber 85 in between, thereby laminating a plurality of the carbon-containing sheets 80 and 82 (see Figure 7(i)). The uncured liquid rubber 85 becomes the silicone rubber 30 after curing, and is preferably liquid silicone rubber. Furthermore, in this embodiment, the uncured liquid rubber 85 serves as an adhesive for bonding the carbon-containing sheets 80 and 82 together. Then, in a state in which the plurality of the carbon-containing sheets 80 and 82 are laminated, the uncured liquid rubber 85 is cured, to form a block body 90 (see Figure 7(j)). The block body 90 is a laminated body in which the carbon fibers 20 contained in the plurality of the carbon-containing sheets 80 and 82 are stacked to have the same orientation direction D1 (see Figure 8(k)). The uncured liquid rubber 85 preferably has a hardness equal to or lower than that of the carbon-containing sheets 80 and 82 after curing. This is because the block body 90 can be prevented from increase in hardness and can be given flexibility. Note that the laminating step (S120) may be performed by laminating the carbon-containing sheets 82 without using the uncured liquid rubber 85 and performing a curing processing such as heating (or cooling).

### (4) Cutting step (S130)

This step is a step of cutting the block body 90 into a sheet shape obliquely with respect to the orientation direction D1 of the carbon fibers 20 (see Figure 8). More specifically, the block body 90 is cut to a predetermined thickness at an angle θ2 greater than 45° and smaller than 85° with respect to the orientation direction D1 of the carbon fibers 20 (see Figure 8(k)). The predetermined thickness is preferably 0.01 mm to 10 mm, more preferably 0.05 mm to 5 mm. In the cutting step (S130), cutting means is not particularly limited as long as it can cut the block body 90 to a predetermined thickness, such as a known cutter or slicer, but it is preferable to slice using a rotary blade as the cutting means. In the cutting step (S130), the carbon fiber 20 is pulled by the cutting means in cutting, so that the diameter Φ1 of the cut surfaces 21 and 22 is made larger than the diameter Φ2 of the region 23 embedded in the rubbery elastic body 10 (see Figures 1 and 2). In the cutting step (S130), it is preferable that the cut surfaces 11 and 12 be cut by the cutting means such that the arithmetic mean roughness Ra of the cut surfaces 11 and 12 is 1.0 µm or more and 1.8 µm or less. Furthermore, in the cutting step (S130), it is preferable that the cut surface be cut by the cutting means such that the ten-point mean roughness Rz of the cut surface is 7.7 or more and 18 µm or less. By cutting the block body 90 in the cutting step (S130) in this way, the heat-dissipating sheet 1 can be manufactured (see Figures 8(l) and (m)). Finally, preferably, the inclined end face of the heat-dissipating sheet 1 may be cut to form a vertical end face. Note that Figure 8(m) shows a view seen in the direction of an arrow F in Figure 8(l).

The heat-dissipating sheet 1 manufactured in this manner has the carbon fibers 20 and the holes 14 embedded obliquely with respect to the thickness direction (up-down direction in Figure 8(m)) (see Figure 8(m)). Furthermore, in the heat-dissipating sheet 1, both the end portions 21 and 22 of the carbon fibers 20 are exposed at the respective cut surfaces (that is, the surfaces 11 and 12 of the rubbery elastic body 10). In the carbon fiber 20, each of the diameters Φ1 of both the end portions 21 and 22 exposed at the cut surfaces 11 and 12 is larger than the diameter Φ2 of the region 23 embedded in the rubbery elastic body 10. Therefore, the heat-dissipating sheet 1 manufactured in this way causes the contact area between the carbon fibers 20 and the heat source or the member on the cooling side to be large, allowing increase in the thermal conductivity. Furthermore, even if an external force is applied in the direction in which the carbon fibers 20 are pulled out (orientation direction Do of the carbon fibers 20), the heat-dissipating sheet 1 can prevent the carbon fibers 20 from being pulled out from the rubbery elastic body 10. Furthermore, since the heat-dissipating sheet 1 is cut in the cutting step (S130) so that the surface roughness is small, the cut surface is flat and the heat source and the carbon fibers 20 can contact each other more reliably. Therefore, thermal conductivity can be further increased. Furthermore, the heat-dissipating sheet 1 has high thermal conductivity as described above, eliminating need to increase the filling rate of the carbon fibers 20 to increase the thermal conductivity. Therefore, the heat-dissipating sheet 1 can prevent increase in hardness due to increase in the filling rate of the carbon fibers 20, and can achieve low hardness and high thermal conductivity. Furthermore, the heat-dissipating sheet 1 is provided with the holes 14 oriented obliquely with respect to its thickness direction, which prevents increase in hardness and reduces stress on the carbon fibers 20 to prevent breakage of the carbon fibers 20 even in deformation due to compression in the thickness direction.

### 3. Other embodiments

At least one of the surfaces 11 and 12 perpendicular to the thickness direction of the heat-dissipating sheet 1 may be coated with a resin. The resin used for this coating is not particularly limited, and examples thereof include thermosetting resins or thermoplastic resins similar to the material of the rubbery elastic body 10 described above. Furthermore, like the rubbery elastic body 10, the coating may contain the above-mentioned resin material and fillers having higher thermal conductivity than that of the resin material. As the fillers, fillers similar to those of the rubbery elastic body 10 can be used. The heat-dissipating sheet 1 configured in this manner allows the coating on the surfaces 11 and 12 to further prevent the carbon fibers 20 from falling off from the rubbery elastic body 10. Furthermore, the heat-dissipating sheet 1 includes a highly thermally conductive fillers in the resin material used for coating, and thereby reduces decrease in thermal conductivity due to coating. When the surfaces 11, 12, 13 of the heat-dissipating sheets 1, 1a are coated with the above-mentioned resin material, the heat-dissipating sheet 1 can be manufactured by coating the surfaces 11 and 12 after the cutting step (S130).

In the method for manufacturing the heat-dissipating sheet 1 described above, the carbon-containing sheet 76 has the depressed portions 78 formed by molding with the mold 60, but the depressed portions 78 may be formed by other techniques such as cutting or etching. In this case, the molding step (S110) just needs to be: forming the carbon-containing sheet 76 without the depressed portions 78 by using an upper mold without the projections and depressions 52 on the inner bottom surface of the recess 51, instead of the upper mold 50; and subsequently forming the depressed portions 78 in the carbon-containing sheet 76 by cutting, etching, or other techniques.

**In** the method for manufacturing the heat-dissipating sheet 1 described above, the carbon-containing sheet 76 is cut out to form two types of the carbon-containing sheets 80 and 82. However, the carbon-containing sheet 80 and the carbon-containing sheet 82 may be individually formed without forming the carbon-containing sheet 76. **In** this case, two types of the carbon-containing sheets 80 and 82 may be individually formed in the molding step by using the same method as that for forming the carbon-containing sheet 76. At this time, it is preferable to use the upper molds 50, which have the projections and depressions 52 on the inner bottom surfaces of the recess 51, respectively corresponding to the arrangement of the depressed portions 78 of two types of the carbon-containing sheets 80 and 82. Furthermore, the molding step may be: forming the carbon-containing sheets 80 and 82 that do not have the depressed portions 78 by using the upper mold 50 that does not have the projections and depressions 52; and subsequently forming the depressed portions 78 in the carbon-containing sheets 80 and 82 by cutting, etching, or other techniques.

Furthermore, the laminating step (S120) may be: laminating a plurality of the carbon-containing sheets 80 and 82 so that the positions of the depressed portions 78 of the carbon-containing sheets 80 and 82 are at the same position in the thickness direction of the carbon-containing sheets 80 and 82.

After the molding step (S110), a trimming step may be performed to trim the excess region of the carbon-containing sheet 76.

### (Second Embodiment)

Next, a second embodiment of the present invention will be described with reference to the drawings. **In** the second embodiment, parts common to those in the first embodiment are denoted by the same reference numerals and characters, and redundant description thereof will be omitted.

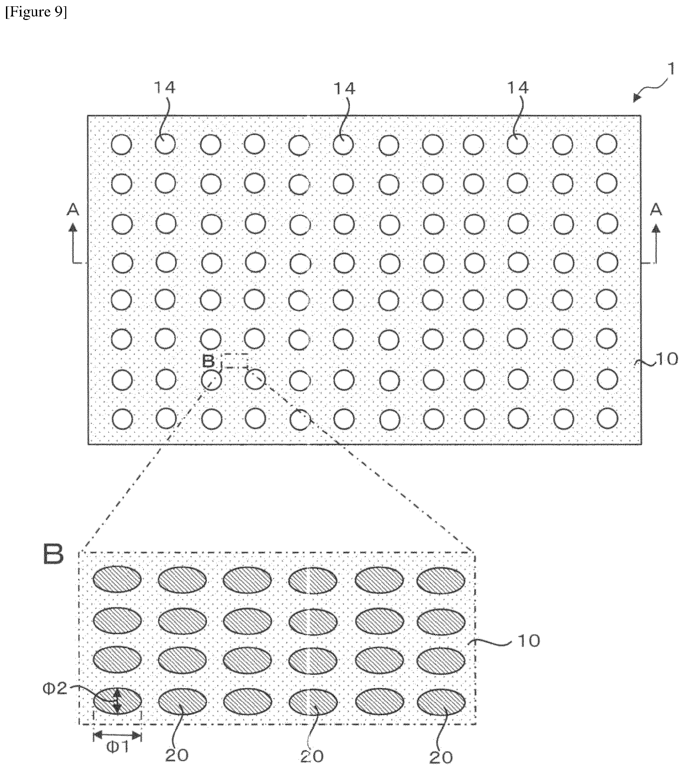

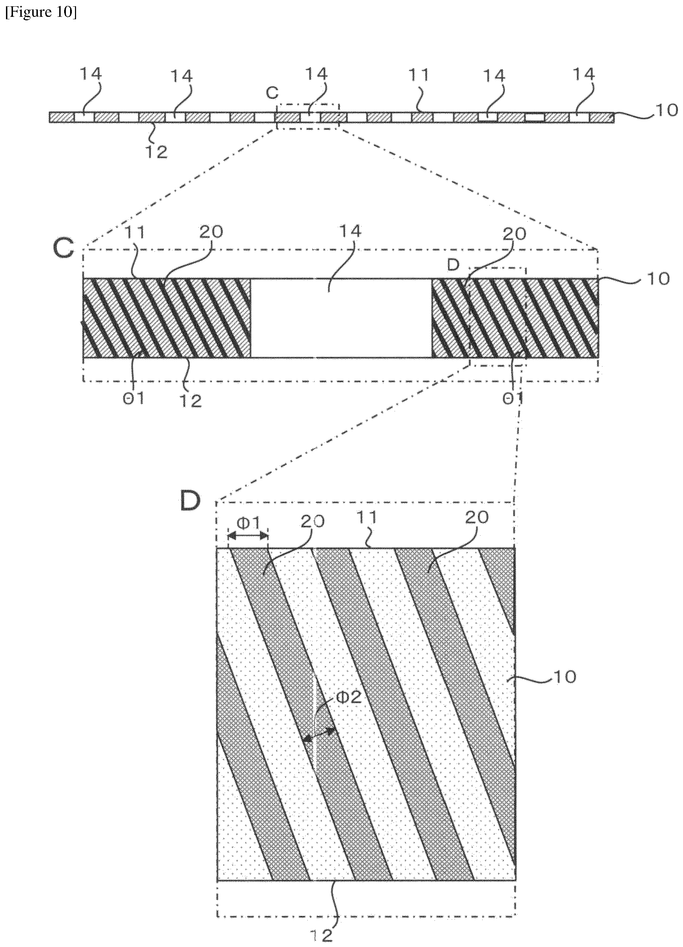

Figure 9 shows a plan view of a heat-dissipating sheet according to the second embodiment of the present invention and an enlarged view of a portion B thereof. Figure 10 shows a cross-sectional view taken along a line A-A of the heat-dissipating sheet in Figure 9, an enlarged view of a portion C thereof, and an enlarged view of a portion D thereof.

The heat-dissipating sheet 1 according to this embodiment includes a sheet-shaped rubbery elastic body 10 and carbon fibers 20 embedded and oriented obliquely with respect to the thickness direction of the rubbery elastic body 10. Unlike the first embodiment, the rubbery elastic body 10 is a single sheet in a non-laminated state. The rubbery elastic body 10 includes at least one hole 14 oriented in its thickness direction. Both end portions of the carbon fiber 20 are exposed on the surfaces of the rubbery elastic body 10. In this embodiment, the hole 14 is a through hole that connects the surfaces 11 and 12 of the rubbery elastic body 10 in the thickness direction. The hole 14 is a through hole parallel to the thickness direction of the rubbery elastic body 10.

In contrast, the carbon fiber 20 are present in the rubbery elastic body 10, and incline at an angle of θ1 (acute angle) with respect to the surface 12 of the rubbery elastic body 10 as in the first embodiment. Preferably, the carbon fiber 20 has a larger diameter Φ1 of each of the portions exposed on the surfaces 11 and 12 of the rubbery elastic body 10 than a diameter Φ2 of a portion embedded in the rubbery elastic body 10. The size ratio of Φ1 to Φ2 is 1 < Φ1/Φ2 < 2 here, more preferably 1.1 <Φ1/Φ2 <1.5. In the heat-dissipating sheet 1, the carbon fiber 20 has portions, each having a diameter Φ1, in contact with the heat source or the cooling member. This increases the contact area between the carbon fiber 20 and the heat source or the cooling member, and can increase the thermal conductivity. Note that the orientation angle θ1 of the carbon fiber 20 is not limited to the above range as long as the orientation angle θ1 is at least oblique with respect to the thickness direction of the rubbery elastic body 10.

The hole 14 exhibits an effect of facilitating the deformation of the heat-dissipating sheet 1, and also exhibits an effect of retaining the lubricant, as will be described later. The lubricant retention effect will be described in detail later.

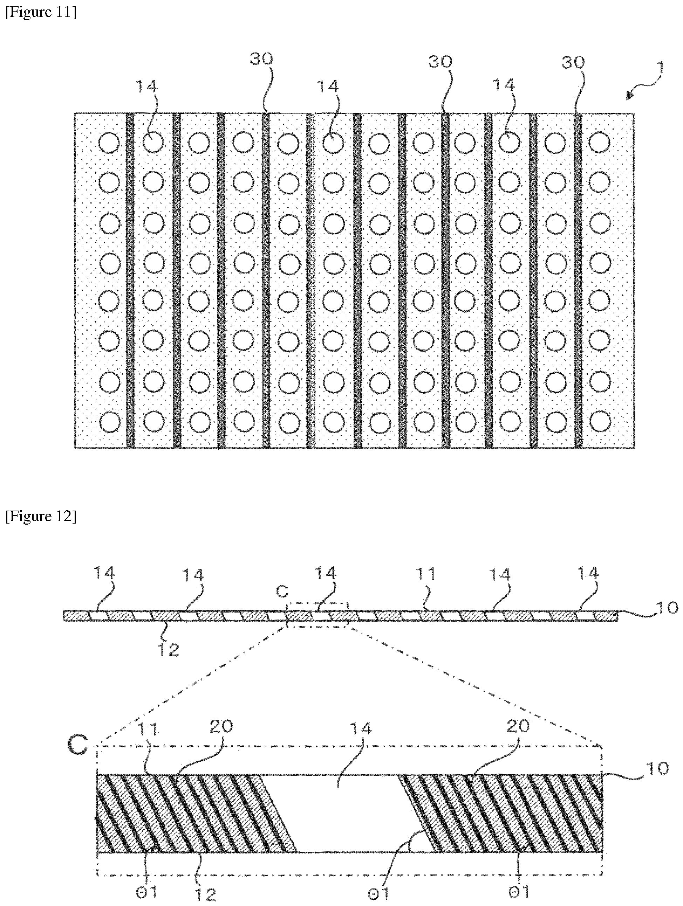

Figure 11 shows a plan view of a first modification of the heat-dissipating sheet of Figure 9.

The heat-dissipating sheet 1 according to the first modification is a laminated sheet of a plurality of sheets, similar to the heat-dissipating sheet 1 according to the first embodiment. In this heat-dissipating sheet 1, silicone rubbers 30, made by curing uncured liquid rubber, are preferably arranged between the plurality of the rubbery elastic bodies 10. In other words, each silicone rubber 30 is arranged between one hole 14 and another hole 14. The silicone rubber 30 is preferably arranged between the rubbery elastic body 10 and the hole 14 in the thickness direction of the heat-dissipating sheet 1. The uncured liquid rubber serves as an adhesive for bonding the rubbery elastic bodies 10 together.

Figure 12 is a diagram showing a second modification of the heat-dissipating sheet in Figure 9, and shows a cross-sectional view similar to the cross-sectional view taken along the line A-A in Figure 9 and an enlarged view of a portion C thereof.

As in the first embodiment, the heat-dissipating sheet 1 according to the second modification includes at least one hole 14 oriented obliquely with respect to the thickness direction of the rubbery elastic body 10. Here, the hole 14 inclines with respect to the surface 12 at an angle of θ1 (acute angle) that is the same as the angle at which the carbon fibers 20 incline with respect to the surface 12. However, the inclination angle of the hole 14 may be different from the inclination angle of the carbon fibers 20.

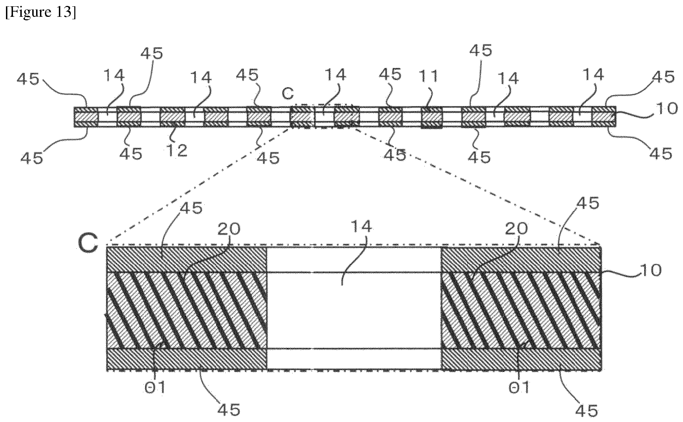

Figure 13 is a diagram showing a third modification of the heat-dissipating sheet of Figure 9, and shows a cross-sectional view similar to the cross-sectional view taken along the line A-A in Figure 9 and an enlarged view of a portion C thereof.

The heat-dissipating sheet 1 according to the third modification has a lubricant coating layer 45 on at least one of the surfaces 11 and 12 of the rubbery elastic body 10. Here, the heat-dissipating sheet 1 is provided with the coating layers 45 on both surfaces 11 and 12. However, the coating layer 45 may be provided only on either one of the surfaces 11 and 12. The coating layer 45 is also provided in a region other than the holes 14 of the rubbery elastic body 10. However, part of the lubricant contained in the coating layer 45 may be present in the holes 14. In that case, it is preferable that not all the holes 14 be filled with the lubricant. This is because, as will be described later, when the coating layer 45 is compressed, it is preferable to leave room for the lubricant, contained in the coating layer 45, to flow into the holes 14 that are not filled with the lubricant. The lubricant in the coating layer 45 and the holes 14 has a high viscosity at which the lubricant does not easily flow from the rubbery elastic body 10, but is preferably softer than the rubbery elastic body 10.

The coating layer 45 is mainly made of grease, which is an example of the lubricant, and is a layer that has a high viscosity and can maintain its shape. Examples of the grease include greases based on modified silicone, silicone oil, or ester oil, that contain fillers with higher thermal conductivity than the base material. Examples of fillers with high thermal conductivity that can be selected are particulate, fibrous, plate-shaped or acicular fillers, typically made of aluminum oxide (Al₂O₃), aluminum nitride (AlN), cubic boron nitride (cBN), hexagonal boron nitride (hBN), zinc oxide, silicon carbide, aluminum hydroxide, or diamond. The fillers with high insulation are more preferred. Furthermore, the above-mentioned base material may be used alone as the grease. The coating layer 45 can prevent the carbon fibers 20 from falling off from the rubbery elastic body 10.

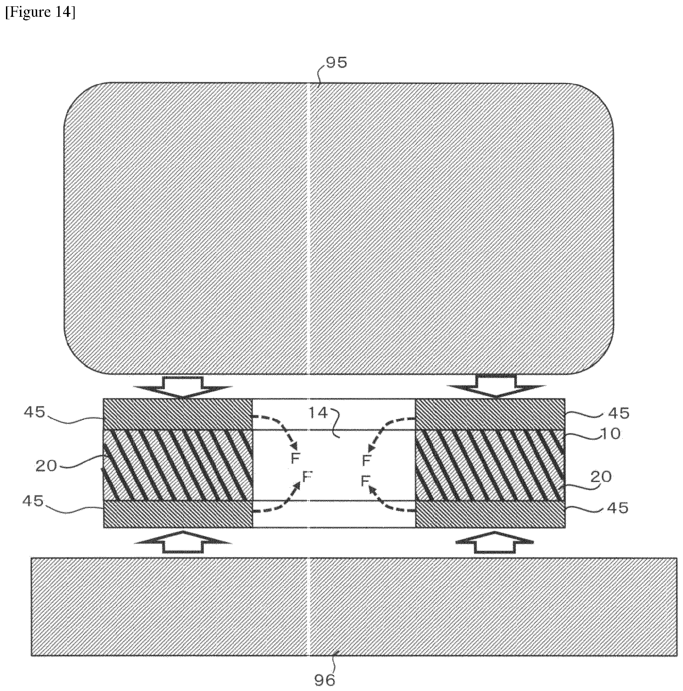

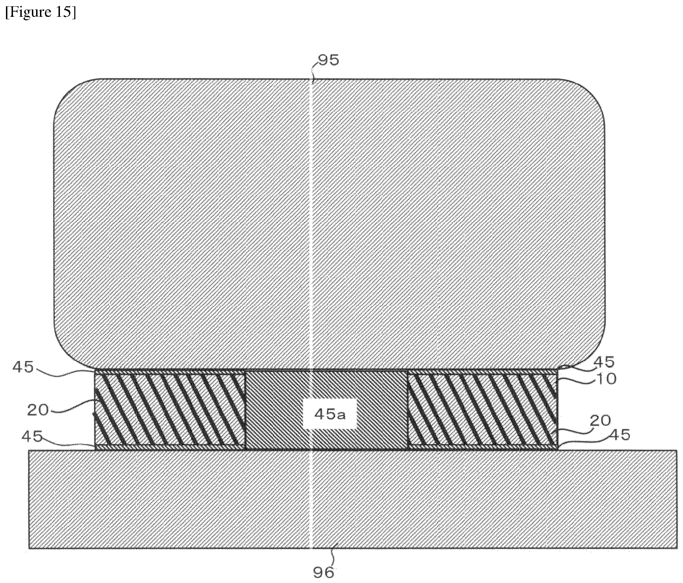

Figure 14 shows a cross-sectional view of a status in which the heat-dissipating sheet according to the third modification is in the middle of being sandwiched between the cooling member and the heat source. Figure 15 shows a cross-sectional view of a status, having progressed further from the status in Figure 14, in which the heat-dissipating sheet has been completely sandwiched between the cooling member and the heat source.

In the present application, the term "cooling member" is broadly interpreted to include, in addition to members that actively cool, members that have a lower temperature than the heat source and can dissipate heat from the heat source. When the heat-dissipating sheet 1 according to the third modification is sandwiched between the cooling member 95 and the heat source 96, the coating layers 45 that are formed on both surfaces of the rubbery elastic body 10 in the thickness direction are compressed and enter the hole 14 as lubricant 45a (see arrows F). In Figure 15, the hole 14 is filled with the lubricant 45a. However, the hole 14 may have a space (where air is present) inside that is not filled with the lubricant 45a. When the lubricant 45a enters the hole 14 with the carbon fibers 20 exposed on the inner wall surface of the hole 14, the lubricant 45a can smoothly transmit the heat transmitted through the carbon fibers 20 from the heat source 96 to the cooling member 95.

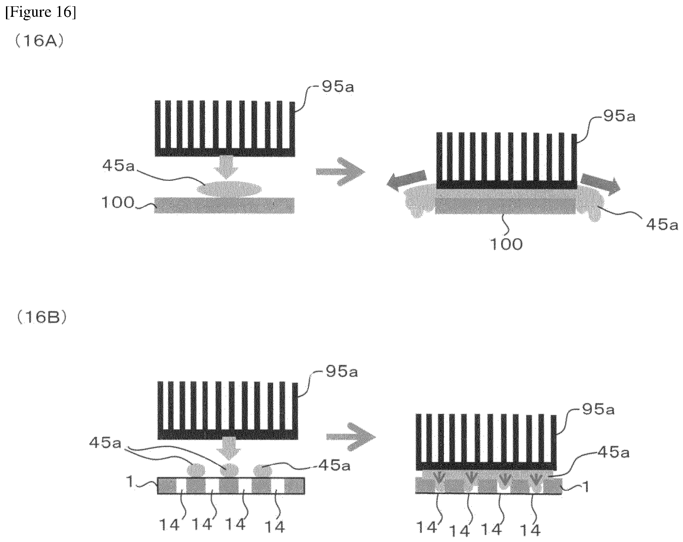

Figure 16 shows a comparison, in cross-sectional views, between: an example (16A) in which a heat sink, which is an example of the cooling member, is brought into contact with a conventional heat-dissipating sheet having no hole with the lubricant supplied on a surface thereof; and an example (16B) in which a heat sink is brought into contact with the heat-dissipating sheet of Figure 9 with the lubricant supplied on a surface thereof. Note that, in Figure 16, a heat source is omitted on the surface opposite to the heat sink of the heat-dissipating sheet.

As shown in (16A), when the lubricant 45a is supplied onto a conventional heat-dissipating sheet 100 having no hole and is pressurized with the heat sink 95a (an example of the cooling member 95) placed on top thereof, the lubricant 45a is highly likely to overflow to the outside of the heat-dissipating sheet 100. As a result, the outside of the heat-dissipating sheet 100 is contaminated with the lubricant 45a.

On the other hand, as shown in (16B), when the lubricant 45a is supplied onto the heat-dissipating sheet 1 according to the second embodiment and is pressurized with the heat sink 95a placed on top thereof, the lubricant 45a enters the holes 14 and is less likely to overflow to the outside of the heat-dissipating sheet 1. This can reduce the possibility of contaminating the outside of the heat-dissipating sheet 1 with the lubricant 45a.

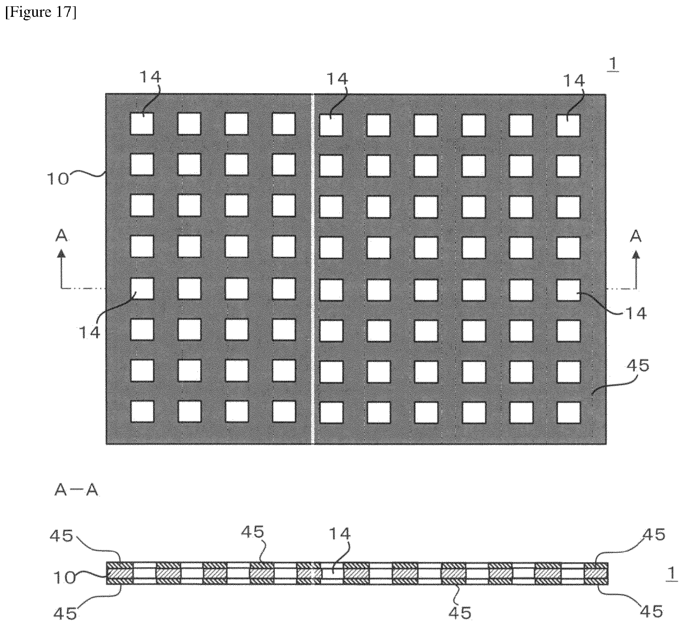

Figure 17 shows a plan view of a heat-dissipating sheet according to a fourth modification and a cross-sectional view taken along a line A-A of the plan view.

The heat-dissipating sheet 1 according to the fourth modification, like the heat-dissipating sheet 1 according to the third modification, has a coating layers 45 of lubricant 45a provided on both the front side surface and the back side surface of the rubbery elastic body 10, and has no lubricant 45a in the holes 14. In contrast, the number of the holes 14 and the shape thereof in plan view are different from those of the third modification. Specifically, in the heat-dissipating sheet 1 according to the fourth modification, the holes 14 are each in a rectangular or square shape in plan view, and a total of 80 holes are provided that are composed of ten columns and eight rows. When such a heat-dissipating sheet 1 is sandwiched between the heat source and the cooling member in the thickness direction, the pressure applied in the thickness direction compresses the rubbery elastic body 10, and causes the lubricant 45a contained in the coating layers 45 to enter the holes 45a. As a result, the risk of the lubricant 45a overflowing to the outside of the heat-dissipating sheet 1 is reduced.

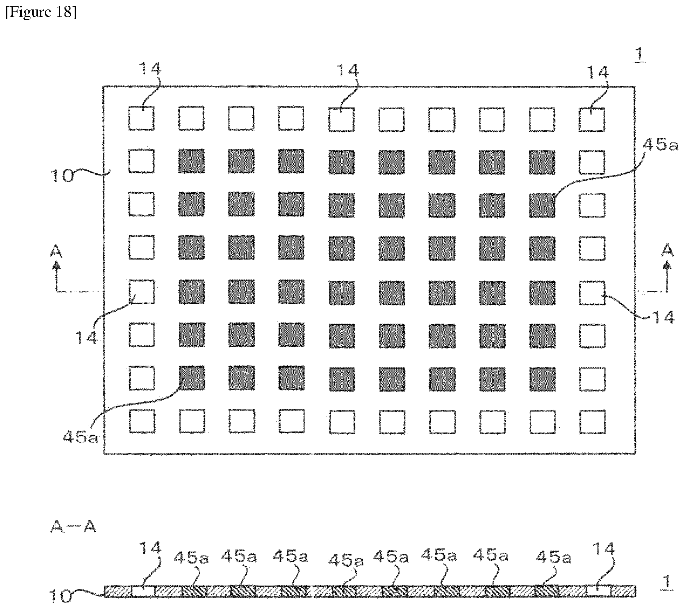

Figure 18 shows a plan view of a heat-dissipating sheet according to a fifth modification and a cross-sectional view taken along a line A-A of the plan view.

The heat-dissipating sheet 1 according to the fifth modification has the same rubbery elastic body 10 as the heat-dissipating sheet 1 according to the fourth modification. In other words, the number and the shape of holes 14 in the fifth modification are the same as those in the fourth modification. The heat-dissipating sheet 1 according to the fifth modification has lubricant 45a in part of the holes 14 among all the holes 14. More specifically, the holes 14 positioned at the outermost circumference in the plane of the rubbery elastic body 10 do not contain the lubricant 45a, and the holes 14, which are positioned in the inner region in the plane relative to the holes 14 positioned at the outermost circumference in the plane, contains the lubricant 45a. Neither the front side surface nor the back side surface of the rubbery elastic body 10 is provided with a coating layer 45. When such a heat-dissipating sheet 1 is sandwiched between the heat source and the cooling member in the thickness direction, the pressure applied in the thickness direction compresses the rubbery elastic body 10, and causes part of the lubricant 45a in the holes 14 to overflow from the holes 45a onto the front side surface and back side surface of the rubbery elastic body 10. At this time, the holes 14 positioned at the outermost circumference in the plane contribute to preventing the lubricant 45a from overflowing to the outside of the heat-dissipating sheet 1. This can further reduce the risk of the lubricant 45a overflowing to the outside of the heat-dissipating sheet 1.

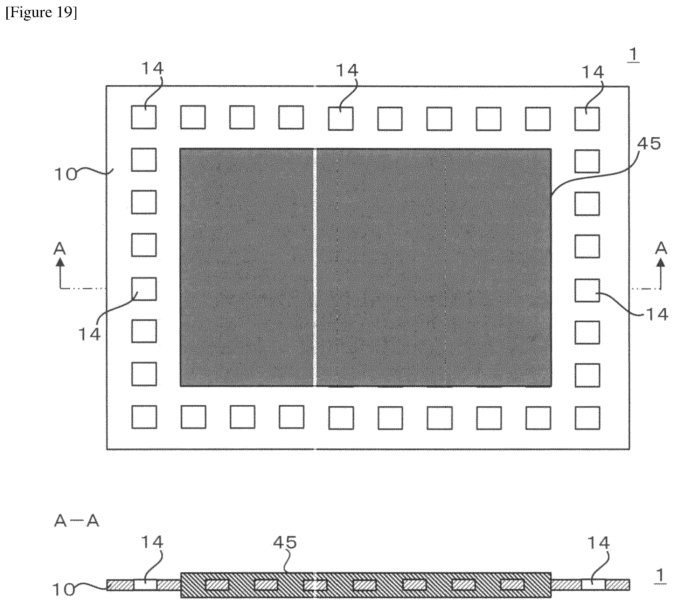

Figure 19 shows a plan view of a heat-dissipating sheet according to a sixth modification and a cross-sectional view taken along a line A-A of the plan view.

The heat-dissipating sheet 1 according to the sixth modification has the same rubbery elastic body 10 as the heat-dissipating sheet 1 according to the fourth modification. In other words, the number and the shape of holes 14 in the sixth modification are the same as those in the fourth modification. The heat-dissipating sheet 1 according to the sixth modification has lubricant 45a in part of the holes 14 among all the holes 14. More specifically, the holes 14 positioned at the outermost circumference in the plane of the rubbery elastic body 10 do not contain the lubricant 45a, and the inner region in the plane relative to the holes 14 positioned at the outermost circumference in the plane has the lubricant 45a. The holes 14 in the inner region in the plane are filled with the lubricant 45a. A coating layer 45 of the lubricant 45a is provided on a portion other than the holes 14 in the inner region in the plane, that is, on the front side surface and the back side surface of the rubbery elastic body 10. Also in such a heat-dissipating sheet 1, like the fifth modification, the holes 14 positioned at the outermost circumference in the plane contribute to preventing the lubricant 45a from overflowing to the outside of the heat-dissipating sheet 1. This can further reduce the risk of the lubricant 45a overflowing to the outside of the heat-dissipating sheet 1.

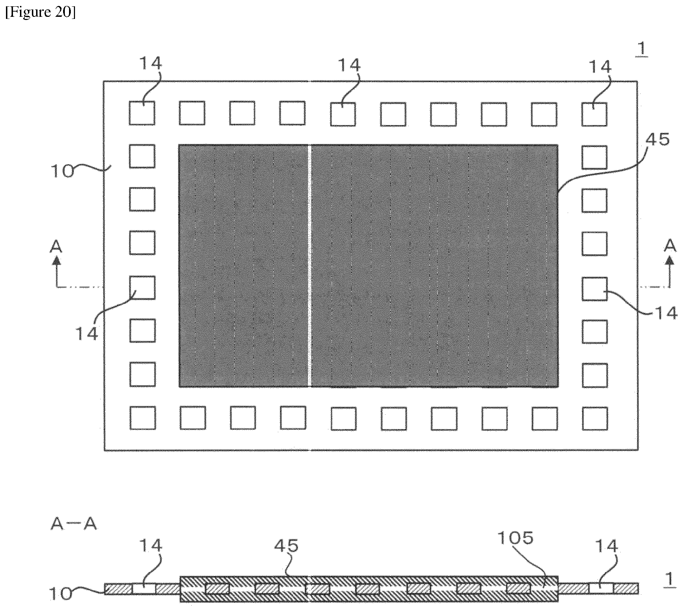

Figure 20 shows a plan view of a heat-dissipating sheet according to a seventh modification and a cross-sectional view taken along a line A-A of the plan view.

The heat-dissipating sheet 1 according to the seventh modification has the same rubbery elastic body 10 as the heat-dissipating sheet 1 according to the fourth modification. In other words, the number and the shape of holes 14 in the seventh modification are the same as those in the fourth modification. In the seventh modification, like the sixth modification, the holes 14 positioned at the outermost circumference in the plane of the rubbery elastic body 10 do not contain the lubricant 45a, and the inner region in the plane relative to the holes 14 positioned at the outermost circumference in the plane has the lubricant 45a. The seventh modification is different from the sixth modification in that the seventh modification has the lubricant 45a in the holes 14 in the inner region in the plane, in which the lubricant 45a does not fill the entire volume of the hole 14 and part of the hole 14 in the length direction is not filled. In other words, in the seventh modification, a space 105 without the lubricant 45a is present in the length direction of the hole 14 containing the lubricant 45a. Such a heat-dissipating sheet 1 can also exhibit the same effect as the sixth modification. Note that, instead of the space 105, a wall that divides the hole 14 into two may be formed.

### (Manufacturing method for first and second embodiments)

The following describes a method for manufacturing the heat-dissipating sheets according to the first embodiment and the second embodiment.

The formation of the holes 14 in the heat-dissipating sheet 1 may be performed after S130 instead of being performed before S120.

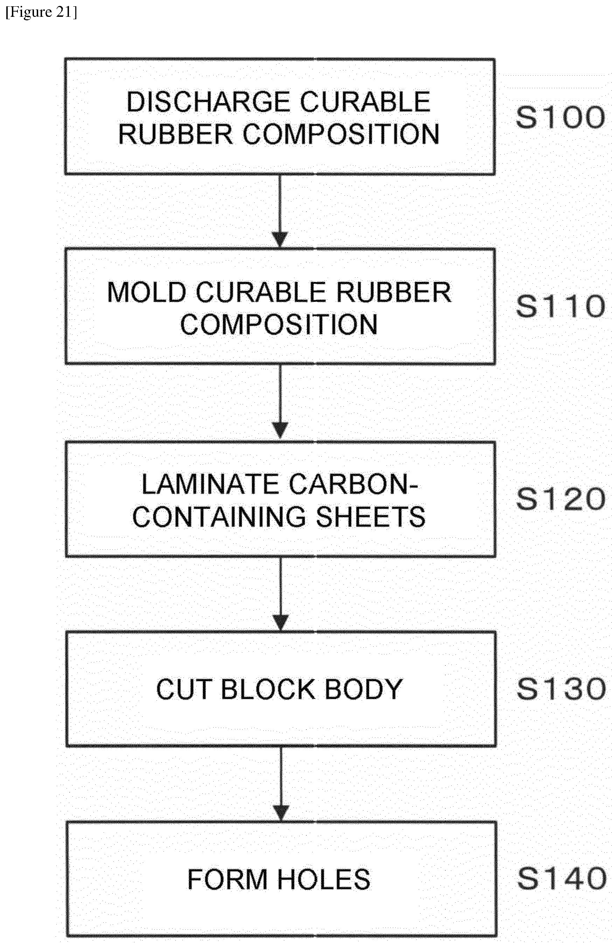

Figure 21 shows a flow of the manufacturing method in which the holes are formed after the cutting step of the block body.

The method for manufacturing the heat-dissipating sheet shown in Figure 21 includes:
a discharge step (S100) of discharging the curable rubber composition 70, containing the carbon fibers 20, onto a plane of the film (an example of a plane body) 72 in a plurality of rows each extending in the first predetermined direction D1;
a molding step (S110) of molding the curable rubber composition 70 discharged onto the plane into a sheet shape and curing the curable rubber composition 70, to form the carbon-containing sheet 76 in which the carbon fibers 20 are oriented in the first predetermined direction D1;
a laminating step (S120) of laminating a plurality of the carbon-containing sheets 76 with the uncured liquid rubber 85 arranged between the carbon-containing sheets 76, and curing the uncured liquid rubber 85, to form the block body 90 that is a laminate having the carbon fibers 20 with the same orientation;
a cutting step (S130) of cutting the block body 90 into a sheet shape obliquely with respect to the orientation direction of the carbon fibers 20; and
a hole forming step (S140) of forming the holes 14 in each rubbery elastic body 10 after the cutting step (see Figures 4 to 8).

In the cutting step (S130), the carbon fibers 20 may be cut into a sheet shape at an angle greater than 45° and smaller than 85° with respect to the orientation direction of the carbon fibers 20.

However, the molding step (S110) in the flow of Figure 21 differs from the molding step (S110) in the flow of Figure 3 in that the depressed portions 78 are not formed in molding. In other words, in the flow of Figure 21, the holes 14 are not formed from the depressed portions 78, but are formed after the cutting step (S130) (hole forming step: S140). The above has described, with reference to Figures 4 to 8, the manufacturing method other than forming the holes 14 after cutting without forming the depressed portions 78 in molding, so repeated description will be omitted here. The flow shown in Figure 21 can also be used in manufacturing the heat-dissipating sheet 1 shown in Figures 9 to 12.

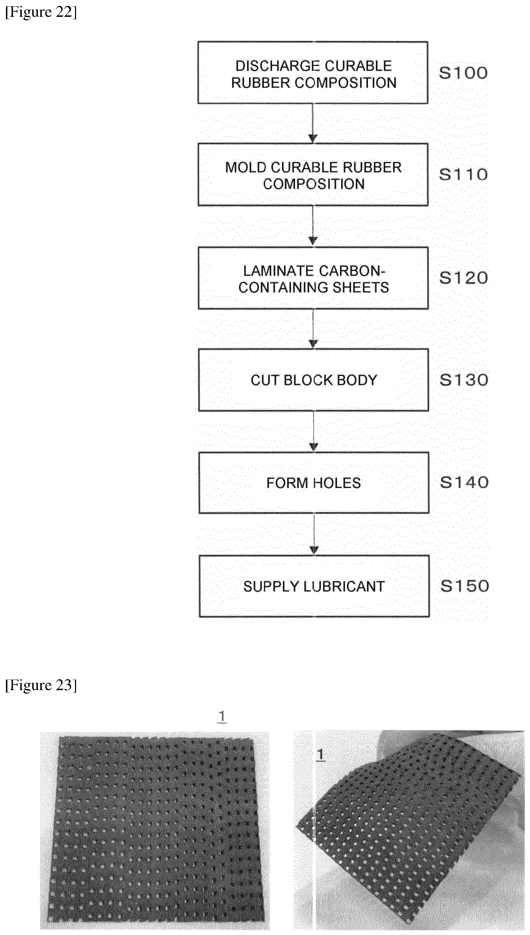

Figure 22 shows the flow of a manufacturing method in which the lubricant is supplied to the rubbery elastic body after the hole forming step.

Figure 22 shows an exemplary method for manufacturing the heat-dissipating sheet 1 according to the second embodiment. In this manufacturing method, after the hole forming step (S140), a lubricant supply step (S150) is performed in which the lubricant 45a is supplied to at least one of the front side surface and the back side surface of the rubbery elastic body 10 and/or the inside of the holes 14. The heat-dissipating sheet 1 according to the third to seventh modifications of the second embodiment can be manufactured through the manufacturing method including the lubricant supply step (S150). The lubricant supply step (S150) is broadly interpreted to include one or both of a step of filling the holes 14 with the lubricant 45a and a step of forming the coating layer 45. Furthermore, the coating layer 45 is broadly interpreted to include, in addition to a layer obtained by supplying the lubricant 45a to the surfaces 11 and 12 of the rubbery elastic body 10, also a layer in which the holes 14 are filled with the lubricant 45a. Note that, before the hole forming step (S140), the lubricant 45a may be supplied to at least one of the front side surface and the back side surface of the rubbery elastic body 10 and/or the inside of the holes 14. For example, in manufacturing the heat-dissipating sheet 1 according to the fourth modification of the second embodiment, the steps may be implemented in order of: the cutting step (S130); followed by the lubricant supply step (S150); followed by the hole forming step (S140) to form the holes 14 and remove the lubricant 45a in those positions.

Figure 23 shows a photograph of the heat-dissipating sheet according to the first modification of the second embodiment.

The two heat-dissipating sheets 1 shown in Figure 23 are the same ones. The entire sheet is black because it contains the carbon fibers 20.

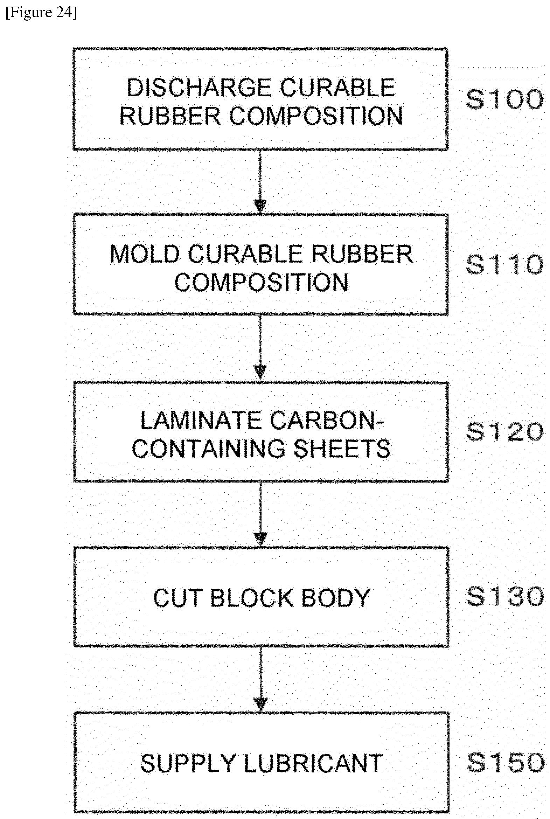

Figure 24 shows a modification of the flow diagram of Figure 22.

The flow diagram of Figure 24 is the one excluding the hole forming step (S140) from the flow diagram of Figure 22. In this case, the holes 14 are formed in a step similar to the molding step (S110) in Figure 3. Therefore, the lubricant 45a just needs to be supplied to the rubbery elastic body 10 immediately after the cutting step (S130). The heat-dissipating sheets 1 according to the third to seventh modifications of the second embodiment can be manufactured through the manufacturing method shown in Figure 24.

### (Other embodiments)

The thermally conductive fillers are not limited to the carbon fibers 20, and other whisker-shaped (acicular) or fibrous elongated fillers may be used. Examples of the elongated fillers include boron nitride, aluminum nitride, and alumina. Likewise, the filler-containing sheet may be a sheet containing elongated fillers other than the carbon fibers 20. The shape of the surface, opening to the surfaces 11 and 12, of the hole 14 is not limited to a circle, an ellipse, or a square, but may be a triangle and a polygon of pentagon or those with more sides.

The heat-dissipating sheet 1 according to the second embodiment (see Figures 9 and 10) may be manufactured by molding one sheet of the rubbery elastic body 10 with the carbon fibers 20 oriented in one direction and then forming the holes 14. To distinguish between the molding step (S110) in the flow of Figures 21 and 22 and the molding step (S110) in the flow of Figure 3, the molding step (S110) in the flow of Figure 3 may be denoted by a first molding step (S110A), and the molding step (S110) in the flows of Figures 21 and 22 may be denoted by a second molding step (S110B). Furthermore, the components of the second embodiment and its various modifications may be combined with each other. For example, the second modification and the third modification may be combined to form the holes 14 oblique with respect to the thickness direction of the rubbery elastic body 10 in the third modification. Furthermore, the third modification and the fourth modification may be combined to form the holes 14 oblique with respect to the thickness direction of the rubbery elastic body 10 in the fourth modification.

### Industrial Applicability

The heat-dissipating sheet according to the present invention can be used for, for example, various electronic devices for automobiles, industrial robots, power generation equipment, PCs, household appliances, etc., batteries for automobiles, rechargeable and dischargeable batteries for home use, batteries for electronic devices such as PCs, and the like.

## Claims

1. A heat-dissipating sheet (1) comprising:
at least one sheet-shaped rubbery elastic body (10); and
an elongated thermally conductive filler (20) that has better thermal conductivity than the rubbery elastic body (10), and is embedded in the rubbery elastic body (10) and obliquely oriented with respect to a thickness direction of the rubbery elastic body (10), wherein
both end portions (21, 22) of the thermally conductive filler (20) are respectively exposed on surfaces (11, 12) of the rubbery elastic body (10), **characterized in that**
the rubbery elastic body (10) has at least one hole (14) oriented obliquely with respect to the thickness direction of the rubbery elastic body (10).

2. The heat-dissipating sheet (1) of claim 1, wherein the thermally conductive filler (20) is embedded in the rubbery elastic body (10) and oriented at an angle (Θ1) greater than 45° and smaller than 85° with respect to a surface (11, 12) of the rubbery elastic body (10).

3. The heat-dissipating sheet (1) of any one of claims 1 to 2, wherein the thermally conductive filler (20) has both the end portions (21, 22), exposed on a surface (11, 12) of the rubbery elastic body (10), each having a diameter (Φ1) larger than a diameter (Φ2) of a region (23) embedded in the rubbery elastic body (10).

4. The heat-dissipating sheet (1) of any one of claims 1 to 3, further comprising a silicone rubber (30), formed of cured liquid rubber, between each rubbery elastic body (10) and the hole (14) or between the rubbery elastic bodies (10) such that the silicone rubber (30) is arranged between the hole (14) of one of the rubbery elastic bodies (10) and the hole (14) of the other of the rubbery elastic bodies (10).

5. The heat-dissipating sheet (1) of claim 4, wherein the liquid rubber (85) is a liquid silicone rubber.

6. The heat-dissipating sheet (1) of any one of claims 1 to 5, wherein each rubbery elastic body (10) is a silicone rubber.

7. The heat-dissipating sheet (1) of any one of claims 1 to 6, wherein at least one of a front side surface (11) and a back side surface (12) of each rubbery elastic body (10) has a coating layer (45) of lubricant.

8. The heat-dissipating sheet (1) of any one of claims 1 to 6, wherein the hole (14) of each rubbery elastic body (10) has lubricant (45a).

9. The heat-dissipating sheet (1) of claim 8, wherein at least one of a front side surface (11) and a back side surface (12) of each rubbery elastic body (10) has a coating layer (45) of the lubricant (45a).

10. The heat-dissipating sheet (1) of claim 8 or 9, wherein the hole (14) positioned at an outermost circumference in a plane of each rubbery elastic body (10) in plan view does not contain the lubricant (45a), and an inner region in the plane relative to the hole (14) positioned at the outermost circumference has the lubricant (45a).

11. The heat-dissipating sheet (1) of any one of claims 1 to **10,** wherein the thermally conductive filler (20) is a carbon fiber.

12. A method for manufacturing a heat-dissipating sheet (1) of any one of claims 1 to 11, comprising:
a discharge step (S100) of discharging curable rubber composition (70), containing the thermally conductive filler (20), onto a plane of a plane body (72) in a plurality of rows each extending in a first predetermined direction (D1);
a molding step (S110) of molding the curable rubber composition (70), discharged onto the plane, into a sheet shape and curing the curable rubber composition (70), to form at least one filler-containing sheet (76), the filler-containing sheet having the thermally conductive filler (20) oriented in the first predetermined direction (D1) and having a surface with at least one depressed portion (78) in a second predetermined direction (D2);
a laminating step (S120) of laminating a plurality of the filler-containing sheets (80, 82) with uncured liquid rubber (85) arranged between the filler-containing sheets (80, 82) and curing the uncured liquid rubber (85), to form a block body (90) that is a laminate having the thermally conductive fillers (20) with the same orientation (D1); and
a cutting step (S130) of cutting the block body (90) into a sheet shape obliquely with respect to an orientation direction (D1) of the thermally conductive filler (20).

13. The method for manufacturing the heat-dissipating sheet (1) of claim 12, wherein the laminating step (S120) laminates the plurality of filler-containing sheets (80, 82) so that positions of the depressed portions (78) are at different positions between the filler-containing sheets (80, 82) in a thickness direction of the filler-containing sheets (80, 82).

14. The method for manufacturing the heat-dissipating sheet (1) of claim 12 or 13, wherein a lubricant supplying step (S150) is performed that supplies lubricant (45a) to at least one of a front side surface (11) and a back side surface (12) of each rubbery elastic body (10) and/or an inside of the hole (14) after the cutting step (S130).

## Patentansprüche

1. Wärmeableitende Lage (1), umfassend:
mindestens einen lagenförmigen gummiartigen elastischen Körper (10); und
einen länglichen wärmeleitfähigen Füllstoff (20), der eine bessere Wärmeleitfähigkeit als der gummiartige elastische Körper (10) aufweist und in den gummiartigen elastischen Körper (10) eingebettet und schräg bezüglich einer Dickenrichtung des gummiartigen elastischen Körpers (10) ausgerichtet ist, wobei
beide Endabschnitte (21, 22) des wärmeleitfähigen Füllstoffs (20) jeweils an Oberflächen (11, 12) des gummielastischen Körpers (10) freigelegt sind, **dadurch gekennzeichnet, dass**
der gummiartige elastische Körper (10) mindestens ein Loch (14) aufweist, das schräg bezüglich der Dickenrichtung des gummiartigen elastischen Körpers (10) ausgerichtet ist.

2. Wärmeableitende Lage (1) nach Anspruch 1, wobei der wärmeleitfähige Füllstoff (20) in den gummiartigen elastischen Körper (10) eingebettet und in einem Winkel (Θ1) größer als 45° und kleiner als 85° bezüglich einer Oberfläche (11, 12) des gummiartigen elastischen Körpers (10) ausgerichtet ist.

3. Wärmeableitende Lage (1) nach einem der Ansprüche 1 bis 2, wobei der wärmeleitfähige Füllstoff (20) beide der Endabschnitte (21, 22) aufweist, die auf einer Oberfläche (11, 12) des gummiartigen elastischen Körpers (10) freigelegt sind, wobei jeder einen Durchmesser (Φ1) aufweist, der größer als ein Durchmesser (Φ2) eines Bereichs (23) ist, der in den gummiartigen elastischen Körper (10) eingebettet ist.

4. Wärmeableitende Lage (1) nach einem der Ansprüche 1 bis 3, ferner umfassend einen Silikongummi (30), ausgebildet aus gehärtetem Flüssiggummi, zwischen jedem gummiartigen elastischen Körper (10) und dem Loch (14) oder zwischen den gummiartigen elastischen Körpern (10), derart, dass der Silikongummi (30) zwischen dem Loch (14) eines der gummiartigen elastischen Körper (10) und dem Loch (14) des anderen der gummiartigen elastischen Körper (10) angeordnet ist.

5. Wärmeableitende Lage (1) nach Anspruch 4, wobei der Flüssiggummi (85) ein Flüssigsilikongummi ist.

6. Wärmeableitende Lage (1) nach einem der Ansprüche 1 bis 5, wobei jeder gummiartige elastische Körper (10) ein Silikongummi ist.

7. Wärmeableitende Lage (1) nach einem der Ansprüche 1 bis 6, wobei mindestens eine von einer Vorderseitenoberfläche (11) und einer Rückseitenoberfläche (12) jedes gummiartigen elastischen Körpers (10) eine Beschichtungsschicht (45) aus Schmiermittel aufweist.

8. Wärmeableitende Lage (1) nach einem der Ansprüche 1 bis 6, wobei das Loch (14) jedes gummiartigen elastischen Körpers (10) Schmiermittel (45a) aufweist.

9. Wärmeableitende Lage (1) nach Anspruch 8, wobei mindestens eine von einer Vorderseitenoberfläche (11) und einer Rückseitenoberfläche (12) jedes gummiartigen elastischen Körpers (10) eine Beschichtungsschicht (45) aus dem Schmiermittel (45a) aufweist.

10. Wärmeableitende Lage (1) nach Anspruch 8 oder 9, wobei das Loch (14), das an einem äußersten Umfang in einer Ebene jedes gummiartigen elastischen Körpers (10) in der Draufsicht positioniert ist, das Schmiermittel (45a) nicht enthält, und ein innerer Bereich in der Ebene relativ zu dem Loch (14), das an dem äußersten Umfang positioniert ist, das Schmiermittel (45a) aufweist.

11. Wärmeableitende Lage (1) nach einem der Ansprüche 1 bis 10, wobei der wärmeleitfähige Füllstoff (20) eine Kohlenstofffaser ist.

12. Verfahren zum Herstellen einer wärmeableitenden Lage (1) nach einem der Ansprüche 1 bis 11, umfassend:
einen Abgabeschritt (S100) zum Abgeben einer härtbaren Gummizusammensetzung (70), die den wärmeleitfähigen Füllstoff (20) enthält, auf eine Ebene eines ebenen Körpers (72) in einer Vielzahl von Reihen, die sich jeweils in eine erste vorbestimmte Richtung (D1) erstrecken;
einen Formgebungsschritt (S110) zum Formen der härtbaren Gummizusammensetzung (70), die auf die Ebene abgegeben wird, in eine Lagenform und zum Härten der härtbaren Gummizusammensetzung (70), um mindestens eine füllstoffhaltige Lage (76) auszubilden, wobei die füllstoffhaltige Lage den wärmeleitfähigen Füllstoff (20) aufweist, der in der ersten vorbestimmten Richtung (D1) ausgerichtet ist, und eine Oberfläche mit mindestens einem vertieften Abschnitt (78) in einer zweiten vorbestimmten Richtung (D2) aufweist;
einen Laminierschritt (S120) zum Laminieren einer Vielzahl der füllstoffhaltigen Lagen (80, 82) mit ungehärtetem Flüssiggummi (85), der zwischen den füllstoffhaltigen Lagen (80, 82) angeordnet ist, und zum Härten des ungehärteten Flüssiggummis (85), um einen Blockkörper (90) auszubilden, der ein Laminat ist, das die wärmeleitfähigen Füllstoffe (20) mit derselben Ausrichtung (D1) aufweist; und
einen Schneideschritt (S130) zum schrägen Schneiden des Blockkörpers (90) in eine Lagenform in Bezug auf eine Ausrichtungsrichtung (D1) des wärmeleitfähigen Füllstoffs (20).

13. Verfahren zum Herstellen der wärmeableitenden Lage (1) nach Anspruch 12, wobei der Laminierschritt (S120) die Vielzahl von füllstoffhaltigen Lagen (80, 82) laminiert, sodass Positionen der vertieften Abschnitte (78) an unterschiedlichen Positionen zwischen den füllstoffhaltigen Lagen (80, 82) in einer Dickenrichtung der füllstoffhaltigen Lagen (80, 82) liegen.

14. Verfahren zum Herstellen der wärmeableitenden Lage (1) nach Anspruch 12 oder 13, wobei ein Schmiermittelzuführungsschritt (S150) durchgeführt wird, der Schmiermittel (45a) zu mindestens einer von einer Vorderseitenoberfläche (11) und einer Rückseitenoberfläche (12) jedes gummiartigen elastischen Körpers (10) und/oder einem Inneren des Lochs (14) nach dem Schneideschritt (S130) zuführt.

## Revendications

1. Feuille de dissipation de chaleur (1) comprenant :
au moins un corps élastique caoutchouteux (10) en forme de feuille ; et
une charge thermoconductrice allongée (20) qui a une meilleure conductivité thermique que le corps élastique caoutchouteux (10), et qui est intégrée dans le corps élastique caoutchouteux (10) et orientée obliquement par rapport à une direction d'épaisseur du corps élastique caoutchouteux (10), dans laquelle
les deux parties d'extrémité (21, 22) de la charge thermoconductrice (20) sont respectivement exposées sur des surfaces (11, 12) du corps élastique caoutchouteux (10), **caractérisée en ce que**
le corps élastique caoutchouteux (10) a au moins un trou (14) orienté obliquement par rapport à la direction d'épaisseur du corps élastique caoutchouteux (10).

2. Feuille de dissipation de chaleur (1) selon la revendication 1, dans laquelle la charge thermoconductrice (20) est intégrée dans le corps élastique caoutchouteux (10) et orientée à un angle (Θ1) supérieur à 45° et inférieur à 85° par rapport à une surface (11, 12) du corps élastique caoutchouteux (10).

3. Feuille de dissipation de chaleur (1) selon l'une quelconque des revendications 1 à 2, dans laquelle la charge thermoconductrice (20) a les deux parties d'extrémité (21, 22), exposées sur une surface (11, 12) du corps élastique caoutchouteux (10), chacune ayant un diamètre (Φ1) supérieur à un diamètre (Φ2) d'une région (23) intégrée dans le corps élastique caoutchouteux (10).

4. Feuille de dissipation de chaleur (1) selon l'une quelconque des revendications 1 à 3, comprenant en outre un caoutchouc de silicone (30), formé de caoutchouc liquide durci, entre chaque corps élastique caoutchouteux (10) et le trou (14) ou entre les corps élastiques caoutchouteux (10) de telle sorte que le caoutchouc de silicone (30) est agencé entre le trou (14) d'un des corps élastiques caoutchouteux (10) et le trou (14) de l'autre des corps élastiques caoutchouteux (10).

5. Feuille de dissipation de chaleur (1) selon la revendication 4, dans laquelle le caoutchouc liquide (85) est un caoutchouc de silicone liquide.

6. Feuille de dissipation de chaleur (1) selon l'une quelconque des revendications 1 à 5, dans laquelle chaque corps élastique caoutchouteux (10) est un caoutchouc de silicone.

7. Feuille de dissipation de chaleur (1) selon l'une quelconque des revendications 1 à 6, dans laquelle au moins l'une parmi une surface latérale avant (11) et une surface latérale arrière (12) de chaque corps élastique caoutchouteux (10) a une couche de revêtement (45) de lubrifiant.

8. Feuille de dissipation de chaleur (1) selon l'une quelconque des revendications 1 à 6, dans laquelle le trou (14) de chaque corps élastique caoutchouteux (10) contient du lubrifiant (45a).

9. Feuille de dissipation de chaleur (1) selon la revendication 8, dans laquelle au moins l'une parmi une surface latérale avant (11) et une surface latérale arrière (12) de chaque corps élastique caoutchouteux (10) a une couche de revêtement (45) du lubrifiant (45a).

10. Feuille de dissipation de chaleur (1) selon la revendication 8 ou 9, dans laquelle le trou (14) positionné au niveau d'une circonférence la plus externe dans un plan de chaque corps élastique caoutchouteux (10) en vue en plan ne contient pas le lubrifiant (45a), et une région interne dans le plan par rapport au trou (14) positionné au niveau de la circonférence la plus externe contient le lubrifiant (45a).

11. Feuille de dissipation de chaleur (1) selon l'une quelconque des revendications 1 à 10, dans laquelle la charge thermoconductrice (20) est une fibre de carbone.

12. Procédé de fabrication d'une feuille de dissipation de chaleur (1) selon l'une quelconque des revendications 1 à 11, comprenant :
une étape de décharge (S100) consistant à décharger la composition de caoutchouc durcissable (70), contenant la charge thermoconductrice (20), sur un plan d'un corps plan (72) dans une pluralité de rangées s'étendant chacune dans une première direction prédéterminée (D1) ;
une étape de moulage (S110) consistant à mouler la composition de caoutchouc durcissable (70), déchargée sur le plan, en une forme de feuille et à durcir la composition de caoutchouc durcissable (70), pour former au moins une feuille contenant une charge (76), la feuille contenant une charge ayant la charge thermoconductrice (20) orientée dans la première direction prédéterminée (D1) et ayant une surface avec au au moins une partie enfoncée (78) dans une seconde direction prédéterminée (D2) ;
une étape de stratification (S120) consistant à stratifier une pluralité de feuilles contenant une charge (80, 82) avec du caoutchouc liquide non durci (85) agencé entre les feuilles contenant une charge (80, 82) et à durcir le caoutchouc liquide non durci (85), pour former un corps de bloc (90) qui est un stratifié ayant la charge thermoconductrice (20) avec la même orientation (D1) ; et
une étape de coupe (S130) consistant à couper le corps de bloc (90) en une forme de feuille obliquement par rapport à une direction d'orientation (D1) de la charge thermoconductrice (20).

13. Procédé de fabrication de la feuille de dissipation de chaleur (1) selon la revendication 12, dans lequel l'étape de stratification (S120) stratifie la pluralité de feuilles contenant une charge (80, 82) de sorte que des positions des parties enfoncées (78) sont à des positions différentes entre les feuilles contenant une charge (80, 82) dans une direction d'épaisseur des feuilles contenant une charge (80, 82).

14. Procédé de fabrication de la feuille de dissipation de chaleur (1) selon la revendication 12 ou 13, dans lequel une étape d'approvisionnement en lubrifiant (S150) est effectuée qui fournit du lubrifiant (45a) à au moins l'une parmi une surface latérale avant (11) et une surface latérale arrière (12) de chaque corps élastique caoutchouteux (10) et/ou un intérieur du trou (14) après l'étape de coupe (S130).
